# EUROPÄISCHE PATENTSCHRIFT

(11) **EP 3 097 593 B1**
(45) Veröffentlichungstag und Bekanntmachung des Hinweises auf die Patenterteilung: **26.08.2020**
(21) Anmeldenummer: 15823590.3
(22) Anmeldetag: 30.11.2015
(51) Int. Cl.: H01L 41/047, B41J 2/14, H01L 41/29

(54) **AKTUATORVORRICHTUNG**
ACTUATOR DEVICE
DISPOSITIF ACTIONNEUR

(30) Priorität: 01.12.2014 DE 102014017746; 01.12.2014 DE 202014009536 U
(43) Veröffentlichungstag der Anmeldung: 30.11.2016
(73) Patentinhaber: PI Ceramic GmbH, 07589 Lederhose (DE)
(72) Erfinder: HENNIG, Eberhard, 07646 Mörsdorf (DE); DITAS, Peter, 07589 Münchenbernsdorf (DE); GRÜNWALD, Frank, 07616 Graitschen (DE)
(74) Vertreter: Stolmár & Partner Patentanwälte PartG mbB
(86) Internationale Anmeldenummer: PCT/EP2015/002406
(87) Internationale Veröffentlichungsnummer: WO 2016/087036

(56) Entgegenhaltungen:
- EP-A1- 1 582 574
- EP-A1- 1 770 798
- DE-A1-102012 023 521
- JP-A- 2012 074 938
- Anonymous: "Bismaleimide Adhesives Technology / Polymerics GmbH", , 8 January 2002 (2002-01-08), XP055344515, Retrieved from the Internet: URL:http://www.polymerics.de/technology/bm i_en.html [retrieved on 2017-02-10]

## Beschreibung

Die Erfindung betrifft eine Aktuatorvorrichtung.

Aus der DE 10 2012 023 521 A1, der EP 1 770 798 A1, der US 5 144 342 A, der US 2010/245490 A1 und der US 2004/227432 A1 ist jeweils eine Aktuatorvorrichtung mit aus einem piezoelektrischen Material gebildeten Aktuatoren bekannt.

Aus der JP 2012-74938 A ist eine piezoelektrische Komponente bekannt.

In der EP 1 582 574 A1 sind elektrisch leitende Mehrkomponenten-Klebstoffe beschrieben.

Die Aufgabe der Erfindung ist, eine Aktuatorvorrichtung mit aus einem piezoelektrischen Material gebildeten Aktuatoren und einer an diese elektrisch angeschlossenen, insbesondere flexiblen Leiterplatte bereitzustellen, die effektiv herstellbar ist und eine große Funktions-Sicherheit gewährleistet.

Diese Aufgabe wird mit den Merkmalen des Anspruchs 1 gelöst. Weitere Ausführungsformen sind in den auf diesen rückbezogenen Unteransprüchen angegeben.

Erfindungsgemäß ist insbesondere eine Aktuatorvorrichtung vorgesehen, die aufweist:
- einen Grundkörper mit einem Basiskörper und einem sich in einer Dickenrichtung oder Y-Richtung von dem Basiskörper erstreckenden Aufbaukörper,
- eine Mehrzahl von den Aufbaukörper bildenden und sich jeweils in einer Tiefenrichtung erstreckenden und aus einem Aktuatorkörper aus einem piezoelektrischen oder elektrostriktiven Material und an oder in diesem angeordneten und voneinander beabstandeten Betätigungselektroden gebildete Aktuatoren, wobei die Aktuatoren in der Längsrichtung der Aktuatorvorrichtung hintereinander angeordnet sind, wobei zwischen jeweils zwei benachbarten Aktuatoren ein Betätigungsbereich-Teilabschnitt einer Ausnehmung ausgebildet ist,
   wobei die Aktuatoren elektrisch leitfähige Aktuator-Anschlussschichten aufweisen, die mit den Betätigungselektroden der Aktuatoren elektrisch in Verbindung stehen, wobei die Aktuator-Anschlussschichten zumindest abschnittsweise gelegen sind
   (i) entweder auf einer in die Dickenrichtung oder Y-Richtung orientierten Oberfläche des Basiskörpers, oder
   (ii) auf einem sich in Tiefenrichtung oder Z-Richtung an einen jeweiligen Aktuatorkörper der Aktuatoren anschließenden Aktuator-Stufenabschnitt der Aktuatoren,
   wobei zwischen Aktuator-Anschlussschichten von jeweils zwei benachbarten Aktuatoren jeweils ein Anschlussbereich-Teilabschnitt einer jeweiligen Ausnehmung gelegen ist,
- eine Leiterplatte, die sich in der Längsrichtung oder X-Richtung der Aktuatorvorrichtung über zumindest Abschnitte der Aktuator-Anschlussschichten erstreckt und deren Leiterbahnen mit den Aktuator-Anschlussschichten in elektrischem Kontakt stehen
wobei in dem Anschlussbereich-Teilabschnitt der jeweiligen Ausnehmung zumindest abschnittsweise eine Verbindungsschicht aus einem Harz-Verstärkungsmaterial derart angeordnet ist, dass die Verbindungsschicht zumindest abschnittsweise einen jeweiligen Anschlussbereich-Teilabschnitt begrenzende und einander gegenüberliegende Seitenflächen, den in die Dickenrichtung weisenden Oberflächenabschnitt des Basiskörpers und den dem Oberflächenabschnitt des Basiskörpers zugewandten Bereich der Leiterplatte berührt, um die Leiterplatte im Bereich des jeweiligen Anschlussbereich-Teilabschnitts einer jeweiligen Ausnehmung abzustützen und an den Aktuator-Anschlussschichten zu fixieren.

Mit der erfindungsgemäßen Aktuatorvorrichtung mit dem Harz-Verstärkungsmaterial, im Folgenden auch kurz als Verstärkungsmaterial bezeichnet, wird erreicht, dass die insbesondere flexible Leiterplatte an die Aktuatoren sowohl elektrisch als auch mechanisch stabil angeschlossen ist. Die erfindungsgemäße Lösung der Aktuatorvorrichtung mit der Verbindungsschicht aus einem ausgehärteten Harz-Verstärkungsmaterial gewährleistet, dass die Herstellung der Aktuatorvorrichtung mit geringem Ausschuss erfolgen kann.

Nach dem Füllen der Ausnehmungen jeweils zwischen zwei benachbarten Aktuatoren kann in noch viskosem Zustand des Verstärkungsmaterials die insbesondere flexible Leiterplatte auf Stufenabschnitte der Aktuatoren aufgelegt und positioniert werden, so dass, wenn eine Mindestmenge des Verstärkungsmaterials in die jeweiligen Ausnehmungen gelegt wurde, das Verstärkungsmaterial zuverlässig in Verbindungskontakt mit den einander zugewandten Seitenflächen der Stufenabschnitte der an der jeweiligen Ausnehmung gelegenen Aktuatoren, der Ausnehmungs-Oberfläche und der dieser zugewandten Unterseite der Leiterplatte gelangt. Nach dem Härten des Verstärkungsmaterials bildet dieses ein Stützteil aus, das die insbesondere flexible Leiterplatte im Bereich des Anschlussbereich-Teilabschnitts einer jeweiligen Ausnehmung unterstützt, und gleichzeitig für eine Fixierung der Leiterplatte an den Aktuator-Anschlussbeschichtungen sorgt. Durch die Verwendung des Verstärkungsmaterials nach der Erfindung wird erreicht, dass nach Einbringen des Verstärkungsmaterials in noch nicht gehärtetem Zustand und dem Aufdrücken der insbesondere flexiblen Leiterplatte auf die Aktuator-Verlängerungen oder Aktuator-Stufenabschnitte hinreichend dünne Klebefugen zwischen der insbesondere flexiblen Leiterplatte und den Aktuator-Stufenabschnitten entstehen, bei denen eine sichere galvanische Verbindung zwischen der Metallisierung der Leiterplatte und den Aktuator-Anschlussbeschichtungen gewährleistet ist.

Das Harz-Verstärkungsmaterial kann insbesondere ein Epoxid-Harz sein.

Das Harz-Verstärkungsmaterial enthält Bismaleid mit einem Anteil zwischen 5 Gew.-% und 90 Gew.-% des Verstärkungsmaterials.

Unter "Bismaleimid" wird hierin insbesondere ein Stoff mit der CAS-Nr. 13676-54-5 verstanden.

Dabei kann das Harz-Verstärkungsmaterial eine Mischung aus Epoxid-Harz und Bismaleimid sein. Insbesondere kann vorgesehen sein, dass das Harz-Verstärkungsmaterial durch Beimischen von pulverförmigem Bismaleimid in Epoxid-Harz hergestellt wird.

Bismaleimid hat gegenüber anderen Harzwerkstoffen wie beispielsweise Epoxid den Vorteil einer wesentlich besseren Temperaturbeständigkeit bzw. der Konstanz mechanischer Eigenschaften und/oder chemischer Eigenschaften über einen großen Temperaturbereich. Somit ist die Stützfunktion bzw. die Fixierfunktion des Verstärkungsmaterials über einen großen Temperaturbereich bzw. bis zu vergleichsweise hohen Temperaturen aufrechterhalten und gewährleistet.

Durch den Anteil von Bismaleimid im Verstärkungsmaterial, also die Verwendung von Bismaleimid-Harz, erfolgt eine Vernetzung im Harz im Wesentlichen durch eine Polyadditionsreaktion, wodurch - gegenüber einem Harz-Verstärkungsmaterial ohne Bismaleimid - beim Härten, das nach dem Einbringen des Verstärkungsmaterials in die jeweiligen Ausnehmungen und aufgrund einer Aktivierung durch Erreichung einer geeigneten Temperaturerhöhung des Verstärkungsmaterials erfolgt, die Vernetzung ohne die Entstehung von unerwünschten Nebenprodukten abläuft.

Bei der Ausführungsform der erfindungsgemäßen Aktuatorvorrichtung, bei der das Harz-Verstärkungsmaterial Bismaleimid aufweist, weist dieses - gegenüber einem herkömmlichen Harz-Verstärkungsmaterial ohne Bismaleimid - eine eine geringere Schwindung beim Härten und einen kleineren thermischen Ausdehnungskoeffizienten auf, so dass die Widerstandsfähigkeit der Verbindung von Leiterplatte mit dem Grundkörper und den Aktuatoren gegen Rissausbreitung und Bruch im Bereich des Verstärkungsmaterials erhöht ist. Dadurch kann die Leitplatte sehr dünn und insbesondere flexibel ausgeführt sein.

Weiterhin wird durch die Verwendung von Verstärkungsmaterial mit Bismaleimid eine günstige Feuchtebeständigkeit erreicht.

Als weiterer Vorteil weist das Verstärkungsmaterial mit Bismaleimid einen Elastizitätsmodul auf, das sich über den Temperaturverlauf betrachtet relativ wenig ändert, so dass die erfindungsgemäße Aktuatorvorrichtung im Betrieb auch bei größeren Temperaturschwankungen auf zuverlässige Weise ein vordefiniertes Verhalten sehr genau einhält.

Erfindungsgemäß werden Nachteile von Bismaleimid-Harzen in Kauf genommen, wie z.B.:
- Hohe Härtungstemperaturen und lange Härtungszeiten
- Große Sprödigkeit unmodifizierter Bismaleimid-Harze.

Bei einer entsprechenden Menge von Harz-Verstärkungsmaterial und dem Auflegen auf die Verlängerungs-Teilschicht erfolgt ein Einfließen des Harz-Verstärkungsmaterials zusätzlich zwischen die jeweiligen Verlängerungs-Teilschichten und der Leiterplatte zur Fixierung der Leiterplatte an der Verlängerungs-Teilschicht gelegen ist, wobei der zwischen diesen gelegene Teil der Verstärkungsmaterial mit dem Teil der Verstärkungsmaterial verbunden ist, der in dem Anschlussbereich-Teilabschnitt der jeweiligen Ausnehmung, die der Verlängerungs-Teilschicht begrenzt, gelegen ist.

Nach dem Auflegen der Leiterplatte auf die Aktuator-Anschlussschichten erfolgt die Aktivierung des Harz-Verstärkungsmaterials und damit die Vernetzung der Moleküle insbesondere durch Polyaddition.

Durch einen geeignet gewählten Temperatur-Zeit-Verlauf beim Aktivieren bzw. beim Härtungsprozess wird mit großer Sicherheit erreicht, dass sich in der jeweiligen Ausnehmung das Bismaleimid-Harz an die die Ausnehmung bildenden Oberflächen anlegt, um die Stützfunktion des Verstärkungsmaterials herzustellen und dass gleichzeitig eine sichere galvanische Verbindung zwischen der Metallisierung der Leiterplatte und den Aktuator-Anschlussbeschichtungen erreicht wird.

Erfindungsgemäß weist das Harz-Verstärkungsmaterial Bismaleimid mit einem Anteil zwischen 5 Gew.-% und 90 Gew.-% des Verstärkungsmaterials auf.

Nach einer Ausführungsform der Aktuatorvorrichtung enthält das Harz-Verstärkungsmaterial Bismaleimid mit einem Mindestanteil von 20 Gew.-% des Verstärkungsmaterials. Dabei kann das Bismaleimid aus 1,1'-(Methylendi-p-phenyllen)bismaleimid bestehen oder gebildet sein.

Nach einer Ausführungsform der Aktuatorvorrichtung weist das Harz-Verstärkungsmaterial ein Acrylat mit einem Anteil zwischen 0,1 Gew.-% und 30 Gew.-% des Verstärkungsmaterials auf. Dadurch wird die Viskosität des Harz-Verstärkungsmaterials bei Raumtemperatur verringert und damit eine bessere Verarbeitung des Harz-Verstärkungsmaterials bei Raumtemperatur erreicht.

Dabei kann das Acrylat aus Triethylen-glycol-dimethacrylat bestehen oder gebildet sein. Insbesondere kann das Acrylat ein Stoff mit der CAS-Nr. 109-16-0 sein.

Durch das Vorsehen von Acrylat in dem Verstärkungsmaterial werden zusätzlich die Haftungseigenschaften des Verstärkungsmaterials und dadurch die Fixierung der Leiterplatte an den Aktuatoren verbessert.

Nach einer Ausführungsform der Aktuatorvorrichtung weist das Harz-Verstärkungsmaterial Acrylat mit einem Anteil zwischen 0,1 Gew.-% und 20 Gew.-% und Bismaleimid mit einem Anteil zwischen 0,1 Gew.-% und 80 Gew.-% auf.

Nach einer Ausführungsform der Aktuatorvorrichtung weist das Harz-Verstärkungsmaterial ein Phenolharz mit einem Anteil zwischen 0,1 Gew.-% bis 40 Gew.-% auf.

Nach einer Ausführungsform der Aktuatorvorrichtung weist das Harz-Verstärkungsmaterial ein Phenolharz mit einem Anteil von zumindest 0,1 Gew.-% bis 40 Gew.-%, ein Acrylat zwischen 0,1 Gew.-% und 30 Gew.-% und Bismaleimid mit einem Anteil zwischen 0,1 Gew.-% und 30 Gew.-% auf.

Das Phenolharz kann aus 4,4'-(Methylethyliden)bis(2-(2-propenyl)phenol) bestehennn oder gebildet sein. Insbesondere kann das Phenolharz ein Stoff mit der CAS-Nr. 1745-89-7 sein.

Nach einer Ausführungsform der Aktuatorvorrichtung ist das Harz-Verstärkungsmaterial mit Bismaleimid durch Beimischen von pulverförmigem Bismaleimid in Epoxid-Harz hergestellt.

Nach einer Ausführungsform der Aktuatorvorrichtung ist das Harz-Verstärkungsmaterial zusätzlich zwischen der Verlängerungs-Teilschicht und der Leiterplatte zur Fixierung der Leiterplatte an der Verlängerungs-Teilschicht gelegen oder angeordnet, wobei der zwischen diesen gelegene Teil des Harz-Verstärkungsmaterials mit dem Teil des Harz-Verstärkungsmaterials verbunden ist, der in dem Anschlussbereich-Teilabschnitt der jeweiligen Ausnehmung gelegen ist.

Nach einer weiteren Ausführungsform der Aktuatorvorrichtung ist vorgesehen, dass an den der Vorderseite zugewandten Oberflächen der Aktuatoren elektrisch leitfähige Vorderseitenbeschichtungen angeordnet sind, die in elektrischem Kontakt mit den Aktuator-Anschlussbeschichtungen stehen, wobei die Vorderseitenbeschichtungen elektrisch mit den Betätigungselektroden der Aktuatoren verbunden sind.

Nach einer weiteren Ausführungsform der Aktuatorvorrichtung ist vorgesehen, dass an der Rückseite der Aktuatorvorrichtung eine elektrisch leitfähige Rückseitenbeschichtung angeordnet ist, die sich in elektrischem Kontakt mit den Betätigungselektroden der Aktuatoren befindet.

Nach einer weiteren Ausführungsform der erfindungsgemäßen Aktuatorvorrichtung ist vorgesehen, dass die Aktuatoren jeweils mindestens zwei innere Betätigungselektroden aufweisen, die sich in positiver Tiefenrichtung von der Vorderseite bis zu einem Abstand zu der Oberfläche an der Rückseite hin erstrecken, und die Aktuatoren jeweils mindestens zwei allgemeine Innen-Elektroden aufweisen, die sich in negativer Tiefenrichtung von der Rückseite bis zu einem Abstand zur Oberfläche an der Vorderseite hin erstrecken, wobei die Betätigungselektroden elektrisch mit den Vorderseitenbeschichtungen verbunden sind und die allgemeinen Innen-Elektroden elektrisch mit der Rückseitenbeschichtung verbunden sind.

Nach einem weiteren Aspekt der Erfindung ist ein Verfahren zur Herstellung einer erfindungsgemäßen Ausführungsform der Aktuatorvorrichtung vorgesehen, wobei das Verfahren die folgenden Schritte aufweist:
- Anordnung des Harz-Verstärkungsmaterials in noch nicht aktiviertem Zustand in dem zumindest einen Anschlussbereich-Teilabschnitt,
- Auflegen der Leiterplatte auf die Aktuator-Anschlussschichten, wobei eine Menge an Harz-Verstärkungsmaterial in dem jeweiligen Anschlussbereich-Teilabschnitt derart angeordnet ist, dass das Harz-Verstärkungsmaterial die den jeweiligen Anschlussbereich-Teilabschnitt begrenzenden Oberflächen berührt, wobei das Harz-Verstärkungsmaterial Bismaleid mit einem Anteil zwischen 5 Gew.-% und 90 Gew.-% des Verstärkungsmaterials enthält,
- Aktivieren des Harz-Verstärkungsmaterials durch Erwärmen desselben zum Vernetzen des Harz-Verstärkungsmaterials.

Generell wird hierin unter dem Ausdruck einer "in eine Richtung weisende Oberfläche" wie z.B. "in die X-Richtung weisende Oberfläche" verstanden, dass die Flächen-Normale der jeweiligen Oberfläche in die genannte Richtung wie z.B. die X-Richtung weist oder in einem spitzen Winkel, in einem Winkel von maximal 45 Grad zu dieser verläuft.

Unter "Beschichtung" wird hierin - soweit keine andere Feststellung getroffen wird - generell verstanden, dass es sich um eine Beschichtung mit einer elektrisch leitfähigen Schicht handelt.

Im Folgenden werden Ausführungsformen der Erfindung an Hand der beiliegenden Figuren beschrieben, die zeigen:

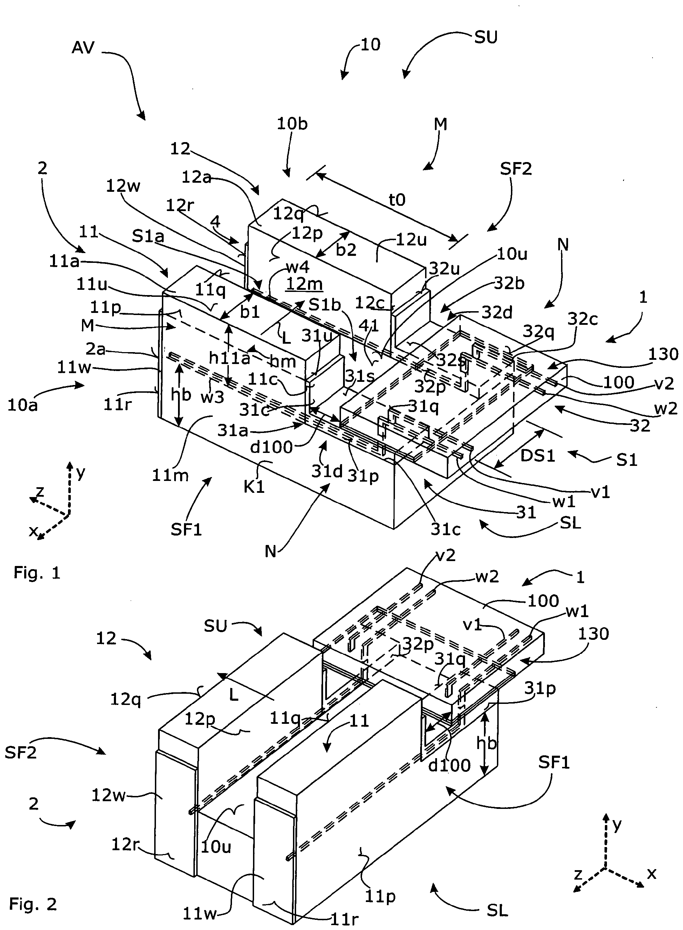

- Figur 1 eine perspektivische Darstellung einer Ausführungsform der erfindungsgemäßen Aktuatorvorrichtung als Ansicht mit einer Blickrichtung auf eine Vorderseite derselben, wobei die Aktuatorvorrichtung einen Grundkörper, aufweisend einen Basiskörper und einen Aufbaukörper mit zwei Aktuatoren, die jeweils einen Aktuatorkörper, äußere Elektroden und eine Aktuator-Anschlussbeschichtung aufweisen, sowie eine Leiterplatte aufweist;
- Figur 2 eine perspektivische Darstellung der in der Figur 1 dargestellten Ausführungsform der erfindungsgemäßen Aktuatorvorrichtung als Ansicht mit einer Blickrichtung auf eine Rückseite derselben;

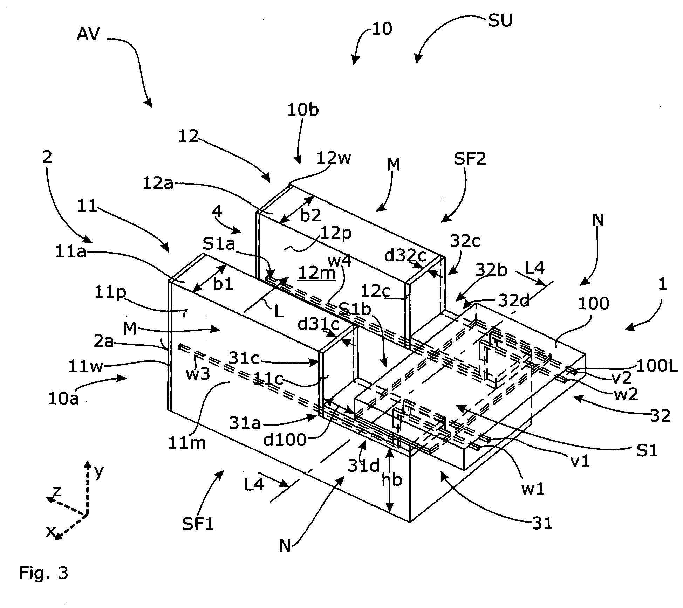

- Figur 3 eine perspektivische Darstellung einer weiteren Ausführungsform der erfindungsgemäßen Aktuatorvorrichtung in der Darstellung der Figur 1, wobei sich die gezeigte Ausführungsform der Aktuatorvorrichtung von der Ausführungsform der Figur 1 dadurch unterscheidet, dass die Aktuator-Anschlussbeschichtung in anderer Weise gestaltet sind;

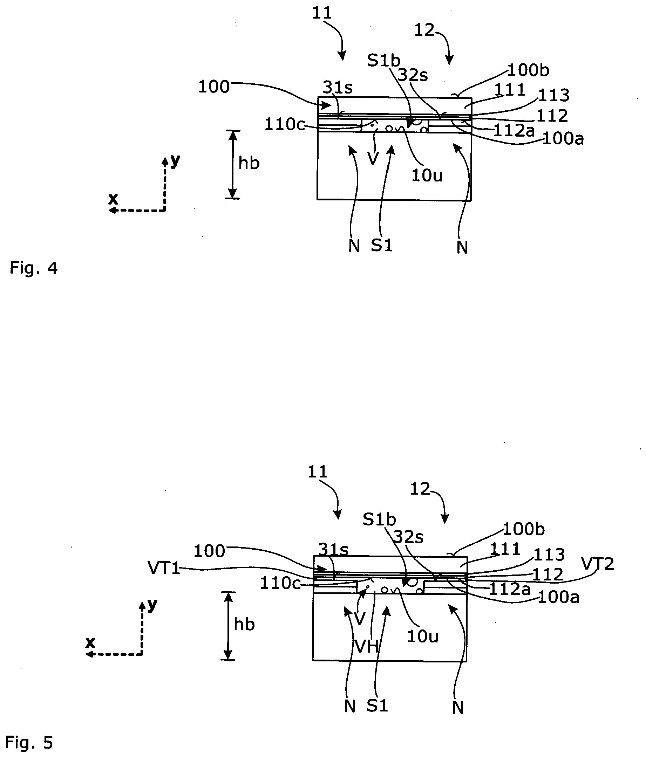

- Figur 4 eine Darstellung des Querschnitts der in der Figur 3 dargestellten Aktuatorvorrichtung entlang der in dieser eingetragenen Linie L4-L4, wobei in einem Zwischenraum, der von dem Grundkörper, den Aktuator-Anschlussbeschichtungen und der Leiterplatte begrenzt ist, erfindungsgemäß diese miteinander verbindend eine Harz-Verstärkungsmaterial gelegen ist; - wobei bei der die Leiterplatte direkt auf Stufenabschnitten der Aktuatoren gelegen ist;
- Figur 5 eine Darstellung des Querschnitts einer Variante der in den Figuren 3 und 4 dargestellten Aktuatorvorrichtung entlang der in der Figur 3 eingetragenen Linie L4-L4, wobei zusätzlich zwischen den Aktuator-Anschlussbeschichtungen und der Leiterplatte diese jeweils miteinander verbindend Harz-Verstärkungsmaterial gelegen ist;

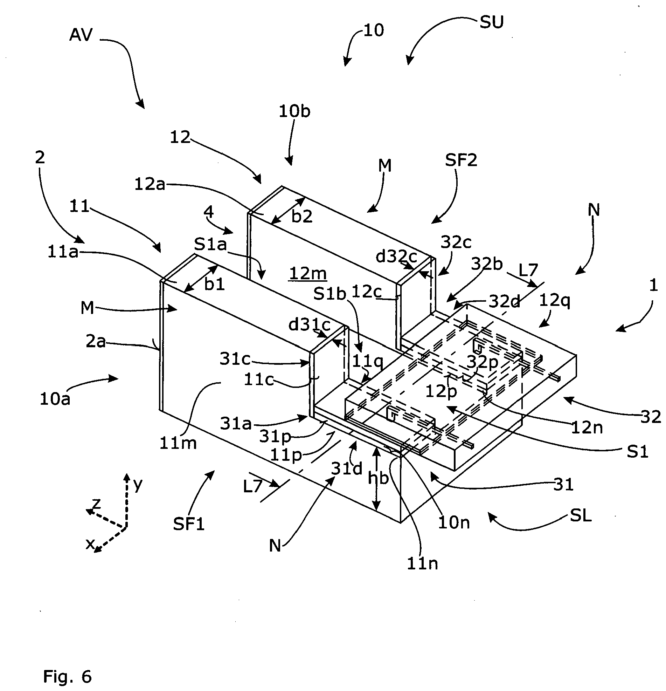

- Figur 6 eine perspektivische Darstellung einer Ausführungsform der erfindungsgemäßen Aktuatorvorrichtung als Ansicht mit einer Blickrichtung auf eine Vorderseite derselben, wobei die Aktuatorvorrichtung einen Grundkörper, aufweisend einen Basiskörper und einen Aufbaukörper mit zwei Aktuatoren, die jeweils einen Aktuatorkörper, äußere Elektroden, einen Stufenabschnitt und eine Aktuator-Anschlussbeschichtung aufweisen, sowie eine Leiterplatte aufweist;

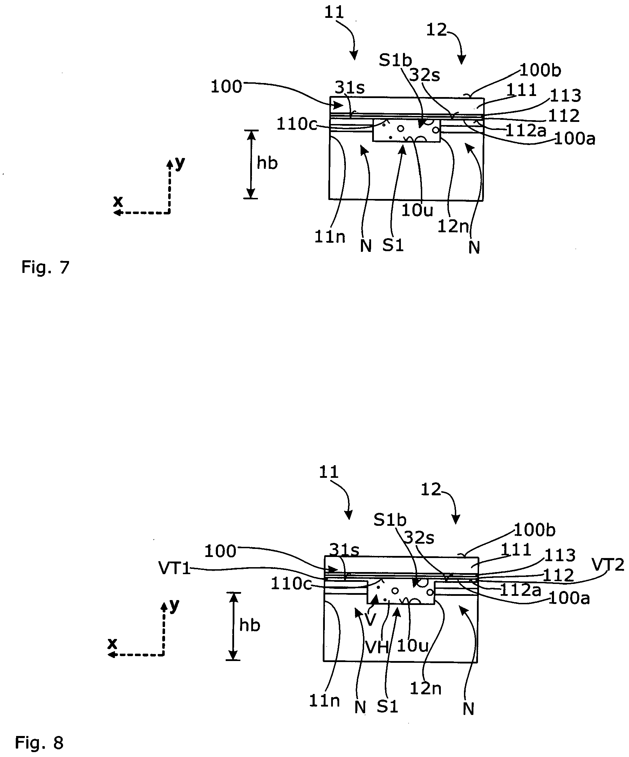

- Figur 7 eine Darstellung des Querschnitts der in der Figur 6 dargestellten Aktuatorvorrichtung entlang der in der Figur 6 eingetragenen Linie L7-L7, wobei in einem Zwischenraum, der von dem Grundkörper, den Aktuator-Anschlussbeschichtungen und der Leiterplatte begrenzt ist, erfindungsgemäß diese miteinander verbindend eine Harz-Verstärkungsmaterial gelegen ist; - wobei bei der die Leiterplatte direkt auf Stufenabschnitten der Aktuatoren gelegen ist;
- Figur 8 eine Darstellung des Querschnitts einer Variante der in der Figur 6 dargestellten Aktuatorvorrichtung entlang der in der Figur 6 eingetragenen Linie L7-L7, wobei zusätzlich zwischen den Aktuator-Anschlussbeschichtungen und der Leiterplatte diese jeweils miteinander verbindend Harz-Verstärkungsmaterial gelegen ist;

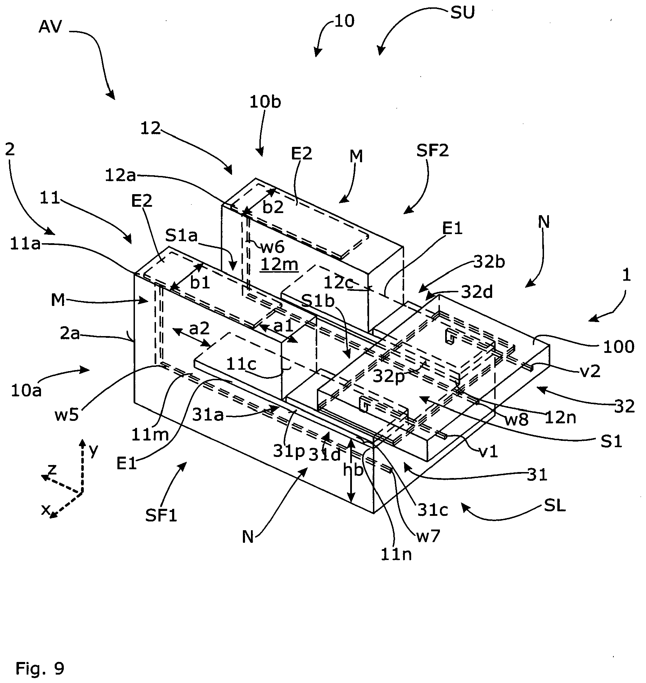

- Figur 9 eine perspektivische Darstellung einer Ausführungsform der erfindungsgemäßen Aktuatorvorrichtung, die sich von der in der Figur 6 dargestellten Aktuatorvorrichtung dadurch unterscheidet, dass jeder Aktuator anstelle von äußeren Betätigungs-Elektroden zwei innere Betätigungs-Elektroden aufweist, wobei jeder Aktuator einen Stufenabschnitt aufweist;

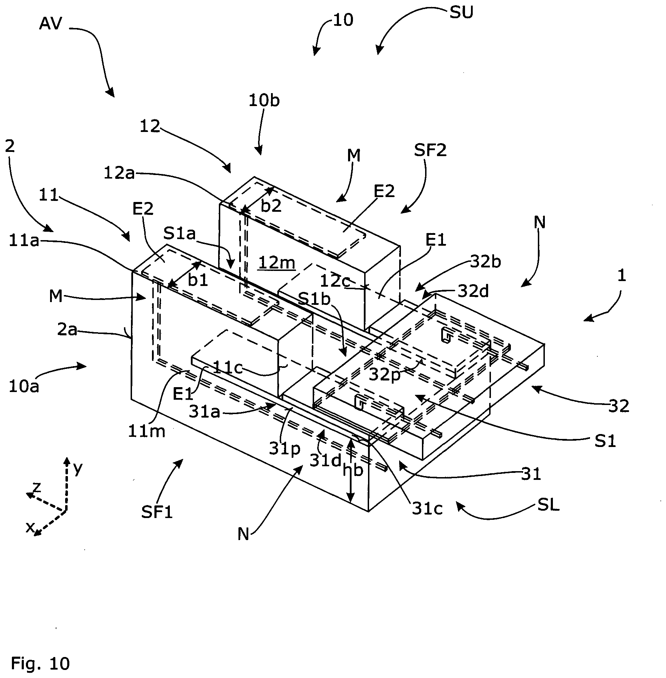

- Figur 10 eine perspektivische Darstellung einer weiteren Ausführungsform der erfindungsgemäßen Aktuatorvorrichtung, die sich von der in der Figur 9 dargestellten Aktuatorvorrichtung dadurch unterscheidet, dass kein Aktuator einen Stufenabschnitt aufweist;

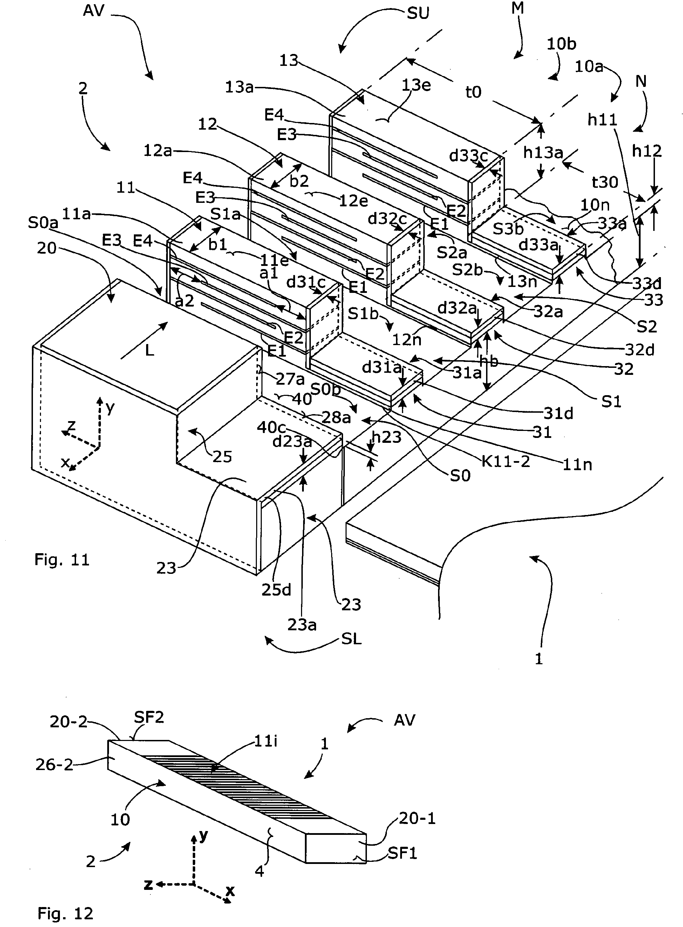

- Figur 11 eine perspektivische Darstellung eines Teils einer weiteren Ausführungsform der erfindungsgemäßen Aktuatorvorrichtung mit einer Blickrichtung auf eine Vorderseite derselben, wobei jeder Aktuator mehrere innere Betätigungs-Elektroden aufweist und wobei die Leiterplatte nicht in einem an den Aktuator-Anschlussbeschichtungen anliegenden Zustand gezeigt ist;
- Figur 12 eine schematische perspektivische Darstellung der in der Figur 11 dargestellten weiteren Ausführungsform der erfindungsgemäßen Aktuatorvorrichtung mit einer Blickrichtung auf eine Rückseite derselben;

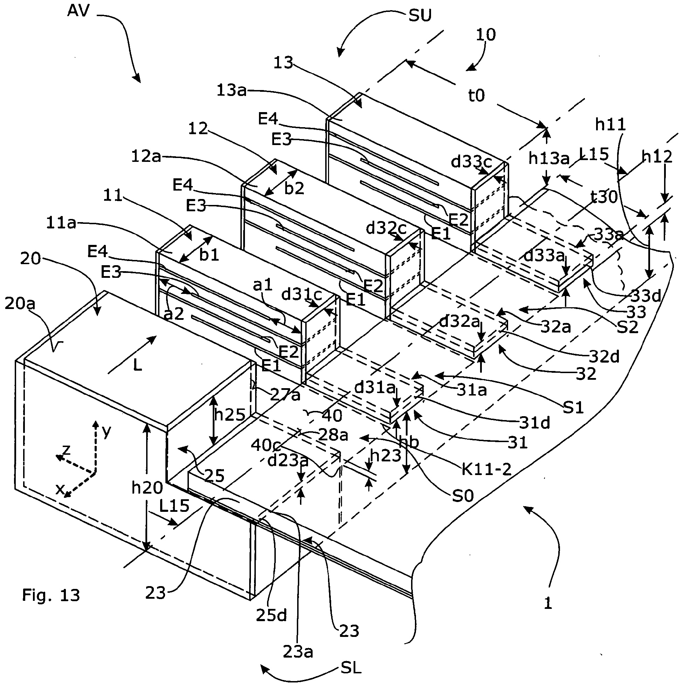

- Figur 13 die Ausführungsform der erfindungsgemäßen Aktuatorvorrichtung nach der Figur 11, wobei die Leiterplatte in einem an den Aktuator-Anschlussbeschichtungen anliegenden Zustand gezeigt ist;

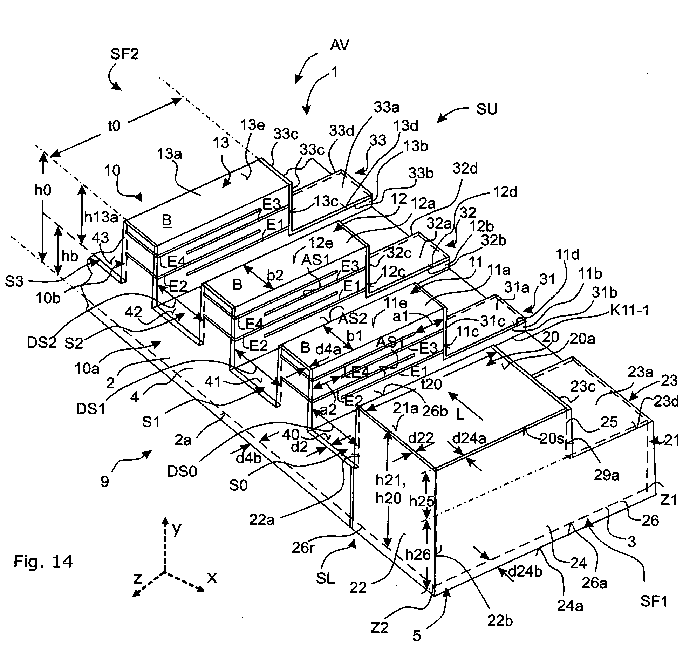

- Figur 14 die Ausführungsform der erfindungsgemäßen Aktuatorvorrichtung nach der Figur 11, ohne Leiterplatte

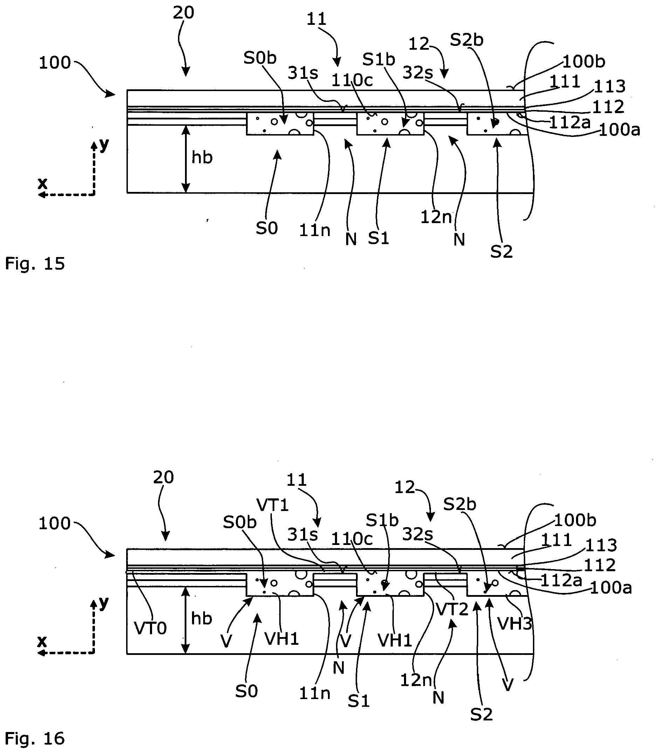

- Figur 15 eine Darstellung des Querschnitts eines Teils der in der Figur 13 dargestellten Aktuatorvorrichtung entlang der in dieser eingetragenen Linie L15-L15, wobei in einem Zwischenraum, der von dem Grundkörper, den Aktuator-Anschlussbeschichtungen und der Leiterplatte begrenzt ist, erfindungsgemäß diese miteinander verbindend ein Harz-Verstärkungsmaterial gelegen ist, wobei die Leiterplatte direkt auf Stufenabschnitten der Aktuatoren gelegen ist;
- Figur 16 eine Darstellung des Querschnitts eines Teils einer Variante der in der Figur 13 dargestellten Aktuatorvorrichtung entlang der in der Figur 3 eingetragenen Linie L15-L15, wobei zusätzlich zwischen den Aktuator-Anschlussbeschichtungen und der Leiterplatte diese jeweils miteinander verbindendes Harz-Verstärkungsmaterial gelegen ist;

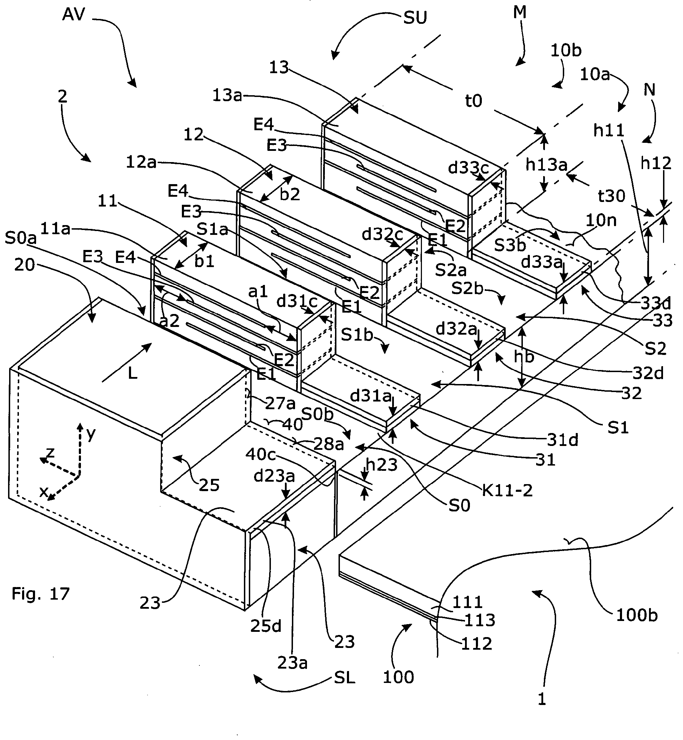

- Figur 17 eine perspektivische Darstellung eines Teils einer weiteren Ausführungsform der erfindungsgemäßen Aktuatorvorrichtung mit einer Blickrichtung auf einer Vorderseite derselben, wobei im Vergleich zur Aktuatorvorrichtung der Figur 13 keiner der Aktuatoren einen Stufenabschnitt aufweist;

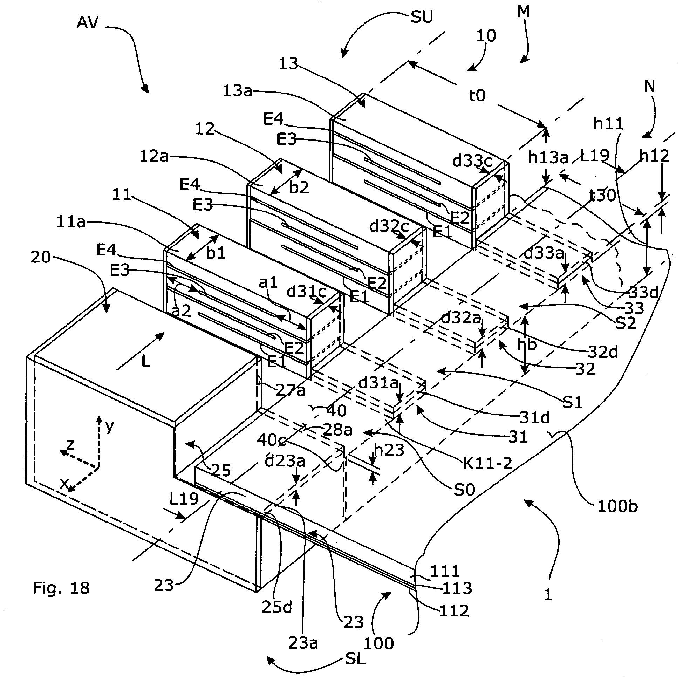

- Figur 18 die Aktuatorvorrichtung der Figur 17 in der Darstellung derselben, wobei an der Anschlussvorrichtung die Leiterplatte gezeigt ist;

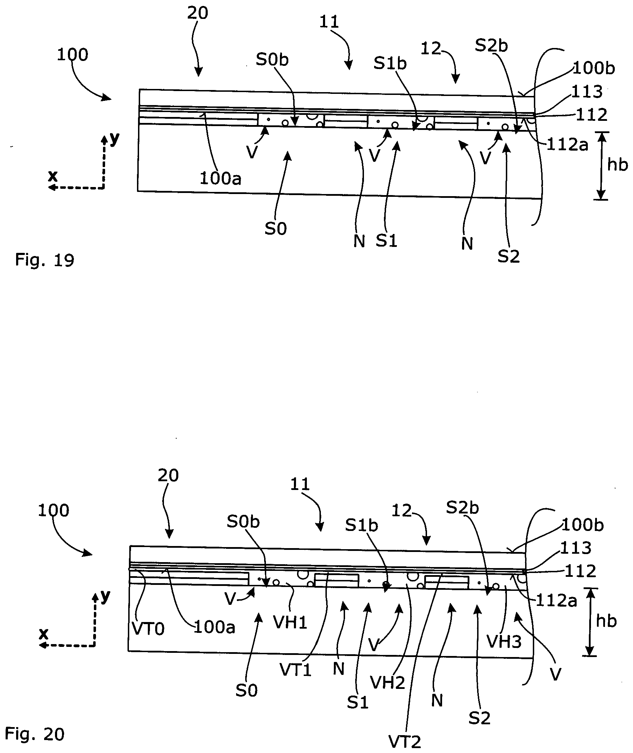

- Figur 19 eine Darstellung des Querschnitts eines Teils der in der Figur 18 dargestellten Aktuatorvorrichtung entlang der in dieser eingetragenen Linie L19-L19, wobei in einem Zwischenraum, der von dem Grundkörper, den Aktuator-Anschlussbeschichtungen und der Leiterplatte begrenzt ist, erfindungsgemäß diese miteinander verbindend ein Harz-Verstärkungsmaterial gelegen ist und wobei die Leiterplatte direkt auf Stufenabschnitten der Aktuatoren gelegen ist;
- Figur 20 eine Darstellung des Querschnitts eines Teils einer Variante der in der Figur 18 dargestellten Aktuatorvorrichtung entlang der in der Figur 3 eingetragenen Linie L19-L19, wobei zusätzlich zwischen den Aktuator-Anschlussbeschichtungen und der Leiterplatte dieses jeweils miteinander verbindendes Harz-Verstärkungsmaterial gelegen ist.

In den Figuren sind Komponenten und Bestandteile mit ähnlicher oder gleicher Funktion teilweise mit jeweils demselben Bezugszeichen versehen.

Die erfindungsgemäße Aktuatorvorrichtung AV weist eine Mehrzahl, d.h.mindestens zwei von aus einem piezoelektrischen oder elektrostriktiven Material und aus voneinander beabstandeten Betätigungselektroden gebildete Aktuatoren auf. Die erfindungsgemäße Aktuatorvorrichtung AV kann jedoch auch eine Vielzahl von Aktuatoren aufweisen, deren Anzahl beispielsweise zwischen 100 und 500 liegt. Bei den in den Figuren 1 bis 10 gezeigten Ausführungsformen der Aktuatorvorrichtung AV weist die Aktuatorvorrichtung AV jeweils zwei Aktuatoren 11, 12 auf. In den Figuren 11 bis 20 sind Ausführungsformen der Aktuatorvorrichtung AV gezeigt, die jeweils mehr als zwei aus einem piezoelektrischen oder elektrostriktiven Material und aus voneinander beabstandeten Betätigungselektroden gebildete Aktuatoren aufweisen, von denen zur besseren Veranschaulichung in den Figuren meist nur drei Aktuatoren 11, 12, 13 gezeigt und entsprechend beschrieben sind. Da die Aktuatoren der Gruppe von Ausführungsformen der Aktuatorvorrichtung AV der Figuren 1 bis 10 grundsätzlich die gleiche Funktion haben wie die Aktuatoren der in den Figuren 11 bis 20 gezeigten Gruppe von Ausführungsformen der Ausführungsformen der Aktuatorvorrichtung AV werden für beide Gruppen von Ausführungsformen dieselben Bezugszeichen verwendet. Dabei sind im Folgenden bei der Verwendung der Bezugszeichen für die drei in den Figuren 11 bis 20 gezeigten Aktuatoren 11, 12, 13 sowie die Bezugszeichen für Bestandteile derselben beide Gruppe von Ausführungsformen der Ausführungsformen der Aktuatorvorrichtung AV gemeint.

Das piezoelektrische oder elektrostriktive Material der Aktuatoren 11, 12, 13 der Aktuatorvorrichtung AV nach der Erfindung wird durch Betätigungselektroden über mit diesen elektrisch verbundenen Aktuator-Anschlussschichten 31d, 32d, 33d aktiviert. Die Betätigungselektroden liegen grundsätzlich in einer Anordnung in oder an den Aktuatoren 11, 12, 13, bei der Abschnitte der Betätigungselektroden in einem Mindestabstand zueinander gelegen sind, wobei zwischen diesen zueinander beabstandeten Abschnitten piezoelektrisches oder elektrostriktives Material gelegen ist, so dass bei Anlegen einer Spannung zwischen diesen Abschnitten piezoelektrische oder elektrostriktive Effekte an dem piezoelektrischen oder elektrostriktiven Material erzeugbar sind.

Die Aktuatoren 11, 12, 13 können dabei elektrisch mittels einer in den Figuren nicht dargestellten elektrischen Erregervorrichtung einzeln betätigt werden, wobei die Betätigungselektroden der Aktuatoren 11, 12, 13 über eine insbesondere flexible Leiterplatte, die in den Figuren schematisch dargestellt ist und in diesen mit dem Bezugszeichen "100" versehen ist, mit der elektrischen Erregervorrichtung elektrisch verbunden sind. Die Betätigungs-Elektroden können an oder in den Aktuatoren 11, 12, 13 in verschiedener Weise ausgeführt und - wie nachfolgend beschrieben wird - aus Betätigungs-Innenelektroden, Betätigungs-Außenelektroden oder beiden gebildet sein.

Zur Beschreibung der erfindungsgemäßen Aktuatorvorrichtung AV ist in den Figuren ein orthogonales Koordinatensystem mit einer X-Richtung entgegen der Längsrichtung L der erfindungsgemäßen Aktuatorvorrichtung AV eingetragen. Die Aktuatoren 11, 12, 13 sind in der Längsrichtung L der erfindungsgemäßen Aktuatorvorrichtung AV gesehen nebeneinander angeordnet. Die Y-Richtung bezeichnet eine Dickenrichtung oder Höhenrichtung der erfindungsgemäßen Aktuatorvorrichtung AV und die Z-Richtung eine Tiefenrichtung oder Breitenrichtung der erfindungsgemäßen Aktuatorvorrichtung AV.

Die Ausführungsformen der Aktuatorvorrichtung AV weisen generell jeweils einen Aktuatorvorrichtungs-Grundkörper 10 oder kurz Grundkörper 10 auf, der einen Basiskörper 10a und einen Aufbaukörper 10b ausbildet, wobei der Aufbaukörper 10b die Aktuatoren 11, 12, 13 mit einer Aktuator-Anschlussschicht 31d, 32d, 33d aufweist, die mit der elektrischen Erregervorrichtung und mit wenigstens einer der zumindest zwei Betätigungs-Elektroden der elektrischen Erregervorrichtung elektrisch verbunden ist. Die Aktuatoren 11, 12, 13 können jeweils einen Aktuator-Stufenabschnitt 11n, 12n, 13n aufweisen, wobei in diesem Fall eine Aktuator-Anschlussschicht 31d, 32d, 33d auf jeweils einem Aktuator-Stufenabschnitt 11n, 12n, 13n gelegen ist. Auch kann die Aktuatorvorrichtung AV eine an einer Rückseite 2 gelegene Rückseitenschicht 4 mit einer Rückseiten-Außenschicht als Betätigungs-Außenelektrode aufweisen, die an einer Rückseite 2 der Aktuatorvorrichtung AV angeordnet ist, wobei die Aktuatoren 11, 12, 13 die Rückseitenschicht 4 bildende Rückseiten-Teilschichten 11z, 12z aufweist (z.B. Figur 1). Beispielsweise können die Rückseitenschicht 4 oder die Rückseiten-Teilschichten 11z, 12z über die Leiterplatte 100 oder über einen Rückführungskörper und dabei optional über die Leiterplatte 100 mit der elektrischen Erregervorrichtung verbunden sein. Auf diese Weise kann bei einer entsprechenden Ansteuerung durch die elektrische Erregervorrichtung eine zueinander gegensätzliche Polung an der Rückseitenschicht 4 oder den Rückseiten-Teilschichten 11z, 12z erreicht werden.

Die Aktuatorvorrichtung AV weist weiterhin auf: eine Vorderseite 1, die in Bezug auf eine Längsrichtung X der Aktuatorvorrichtung AV entgegengesetzt zu der Vorderseite 1 gelegene Rückseite 2, eine in negativer Y-Richtung weisende Unterseite SL sowie eine in positiver Y-Richtung weisende Oberseite SU. Die Vorderseite 1 befindet sich in Längsrichtung oder X-Richtung gesehen und in Bezug auf den Ort der Aktuatoren 11, 12, 13 auf einer Seite, die entgegen gesetzt zur Rückseite 2 gelegen ist, so dass die Vorderseite 1 in Bezug auf die Aktuatoren 11, 12, 13 jenseits der Rückseite 2 angeordnet ist. Die Rückseite 2 des Grundkörpers 10 ist aus einer Oberfläche 2a gebildet, die eine einheitliche und insbesondere ebene Oberfläche darstellen kann. Unter "einheitlich" wird in diesem Zusammenhang verstanden, dass sich die Oberfläche entlang der X-Richtung erstreckt. Insbesondere kann dabei vorgesehen sein, dass die Oberfläche 2a eine über ihre Erstreckung einheitliche Krümmung aufweist, also keinen Wendepunkt besitzt. Weiterhin weist die Aktuatorvorrichtung AV jeweils in X-Richtung gesehen gegenüberliegende Stirnseiten, z.B. 11q, 12p auf.

In den dargestellten Ausführungsformen der erfindungsgemäßen Aktuatorvorrichtung AV sind die Aktuatoren 11, 12, 13 in Z-Richtung nebeneinander und entgegen oder in X-Richtung hintereinander derart angeordnet. Dabei ist zwischen jeweils zwei Aktuatoren - also z.B. zwischen den Aktuatoren 11 und 12 oder zwischen den Aktuatoren 12 und 13 -jeweils eine Ausnehmung S1 bzw. S2 mit einer sich in der X-Richtung erstreckenden Breite DS1 bzw. DS2 und in die Y-Richtung weisenden Oberflächen 41 bzw. 42 ausgebildet:
- bei den Ausführungsformen der Aktuatorvorrichtung AV nach den Figuren 1 bis 10 mit zwei Aktuatoren 11, 12 ist zwischen den Aktuatoren 11 und 12 eine Ausnehmung S1 mit einer sich in der X-Richtung erstreckenden Breite DS1 und einer in die Y-Richtung weisenden Oberfläche 41 als Teil der Oberfläche 10u des Basiskörpers 10a ausgebildet, und
- bei den Ausführungsformen der Aktuatorvorrichtung AV nach den Figuren 11 bis 20 sind zwischen jeweils zwei Aktuatoren - also beispielsweise zwischen den Aktuatoren 11 und 12 oder zwischen den Aktuatoren 12 und 13 -jeweils eine Ausnehmung S1 bzw. S2 mit der sich in der X-Richtung erstreckenden Breite DS1 bzw. DS2 und den in die Y-Richtung weisenden Oberflächen 41 bzw. 42 ausgebildet ist.

Die jeweiligen Ausnehmungen S1, S2 werden in der Z-Richtung gesehen umgrenzt und somit gebildet von der Oberfläche 41 bzw. 42 und den einander zugewandten Seiten 11q, 12p und 12q, 13q jeweils benachbarter Aktuatoren 11 und 12 bzw. 12 und 13. Bei einer Aktuatorvorrichtung AV mit mehr als drei Aktuatoren kann die sich in der in der X-Richtung erstreckende Breite DS1, DS2 zwischen in der X-Richtung benachbart zueinander gelegenen Aktuatoren 11 und 12 bzw. 12 und 13 insbesondere gleich groß sein. Alternativ können auch unterschiedliche Breiten DS1, DS2 vorgesehen sein.

Der Basiskörper 10a erstreckt sich in der positiven Y-Richtung gesehen bis zu den in die positive Y-Richtung weisenden Oberflächen 10u bzw. 41, 42 der Ausnehmungen S1 bzw. S2, die die einander zugewandten Seiten 11q, 12p und 12q, 13q jeweils benachbarter Aktuatoren 11 und 12 bzw. 12 und 13 verbinden. Der Basiskörper 10a ist aus einem Substratkörper K1 und gegebenenfalls mit an diesem angeordneten Außenschichten wie z.B. der Rückseitenschicht 4 gebildet. Der Substratkörper K1 reicht in Y-Richtung bis in eine Höhe hb. An dieser Stelle erstrecken sich die Aktautor-Körper 10a, 11,a, 12a in Y-Richtung von dem Substratkörper K1.

Bei den Ausführungsformen der erfindungsgemäßen Aktuatorvorrichtung AV nach den Figuren 1 bis 10 reicht der Basiskörper 10a in der positiven Y-Richtung gesehen bis zu der Oberfläche 10u der Ausnehmung S1 bzw. bis zu den in die Y-Richtung weisenden Oberflächen zwischen den Aktuatorkörpern 11a, 12a, 13a. Bei den Ausführungsformen der erfindungsgemäßen Aktuatorvorrichtung AV nach den Figuren 11 bis 20 reicht der Basiskörper 10a in der positiven Y-Richtung gesehen bis zu den Oberflächen 40, 41, 42 der Ausnehmungen S0, S1, S2 . In den Figuren 11 bis 20 ist beispielartig die Höhe hb des Basiskörpers 10a eingetragen.

Insbesondere kann bei den Ausführungsformen der Aktuatorvorrichtung AV vorgesehen sein, dass der Substratkörper K1 als Block gebildet ist, so dass der Substratkörper K1 einheitlich aus einem Basismaterial gebildet sein kann. Dabei kann auch vorgesehen sein, dass die Außenkontur, die aus den Außenflächen des Grundkörpers 10 gebildet ist, eine Quaderform hat. Die virtuelle Oberseite des Grundkörpers 10 ist bei den Ausführungsformen nach den Figuren 1 bis 10 teils aus der Oberfläche 40 bzw. bei den Ausführungsformen nach den Figuren 12 bis 14 den Oberflächen 40, 41, 42 und den virtuell innerhalb der Aktuatoren verlaufenden zwischen diesen gelegenen und diese verbindenden Verbindungsflächen gebildet. Die virtuellen Verbindungsflächen können insbesondere derart definiert sein, dass diese zwischen den jeweiligen Oberflächen 40, 41, 42 der Oberfläche 10u über die gesamte jeweilige Verbindungsfläche gesehen eine möglichst geringe Wölbung aufweisen. Die Aktuatorkörper 11a, 12a, 13a sind vorzugsweise mit dem Substratkörper K1 verbunden und insbesondere mit diesem einstückig hergestellt. In dem Fall, in dem die Aktuatorkörper 11a, 12a, 13a als von dem Substratkörper K1 getrennte Teile hergestellt werden, sind diese in ihrem jeweiligen Verbindungsbereich zu dem Substratkörper K1 flächig und fest mit diesem verbunden, so dass weder der Aktuator 11, 12, 13 insgesamt noch ein Teilabschnitt des jeweiligen Aktuators 11, 12, 13 eine Bewegungsfreiheit gegenüber dem Grundkörper 10 besitzt.

Generell können an Rückseiten-Oberflächen 11r, 12r der Aktuatoren 11 bzw. 12 Rückseiten-Teilschichten 11w, 12w oder Anschlussschichten angeordnet sein, an denen durch die elektrische Erregervorrichtung eine Polung erzeugt wird, die der an der bzw. den äußeren oder inneren Betätigungs-Elektrode bzw. Betätigungs-Elektroden der Aktuatoren 11, 12, 13 anliegenden Polung entgegen gesetzt ist, um die piezoelektrischen oder elektrostriktiven Effekte an bzw. in den Aktuatoren 11, 12, 13 zu erzeugen. Die Anschlussschichten 11z, 12z können hierbei eine zusammenhängende Rückseitenschicht 4 bilden.

Die Aktuatoren 11, 12, 13 weisen jeweils Betätigungs-Elektroden auf, die an oder in einem jeweiligen Aktuatorkörper 11a, 12a, 13a zumindest abschnittsweise voneinander beabstandet angeordnet sind. Diese Betätigungs-Elektroden jeweils eines Aktuators 11, 12, 13 können zumindest durch eine oder beide der folgenden Kombinationen realisiert sein:
(a) zumindest zwei innere Betätigungs-Elektroden, die sich innerhalb des jeweiligen Aktuators erstrecken und dabei in einem in der Y-Richtung verlaufenden Abstand zueinander verlaufen (Figuren 9, 10, 11, 13);
(b) zumindest zwei an zwei zueinander entgegen gesetzt gelegenen und jeweils in Z-Richtung und entgegen die Z-Richtung weisenden Außenseiten eines jeweiligen Aktuators gelegene äußere Betätigungs-Elektroden (Figuren 1, 3, 6), die mit den Bezugszeichen 31c, 32c, 33c bezeichnet sind, wobei die zueinander entgegen gesetzt gelegenen Außenseiten gemäß der Figuren 1, 2, 5 in bzw. entgegen gesetzt zur X-Richtung oder in bzw. entgegen gesetzt zur Z-Richtung gerichtet sein können.

Die Aktuatoren 11, 12, 13 weisen jeweils einen von dem Basiskörper 10a abstehenden Aktuator-Betätigungsabschnitt 11m, 12m, 13m, der generell auch mit dem Bezugszeichen "M" bezeichnet ist, und einen daran anschließenden Aktuator-Anschlussabschnitt auf, der generell auch mit dem Bezugszeichen "N" bezeichnet ist und der jeweils eine Aktuator-Anschlussschicht 31d, 32d, 33d und -je nach Ausführungsform - optional einen Aktuator-Stufenabschnitt 11n, 12n, 13n aufweist. Im vorgenannten Fall (a) ist der Aktuator-Betätigungsabschnitt 11m, 12m, 13m der jeweiligen Aktuatoren 11, 12, 13 als jeweils von dem Basiskörper 10a der Aktuatorvorrichtung AV abstehendes Teil mit den jeweiligen inneren Betätigungs-Elektroden gebildet. Im vorgenannten Fall (b) weisen die jeweiligen Aktuatoren 11, 12, 13 jeweils einen Aktuator-Betätigungsabschnitt 11m, 12m, 13m und jeweils eine elektrisch leitfähige Aktuator-Außenelektrodenschicht 31c bzw. 32c bzw. 33c als äußere Elektrode auf, die auf der entgegen die Z-Richtung weisenden Vorderfläche 11c bzw. 12c bzw. 13c gelegen ist und mit jeweils einer elektrisch leitfähigen Aktuator-Anschlussschicht 31d, 32d, 33d verbunden ist. Auch Kombinationen der Optionen (a) und (b) können bei der Aktuatorvorrichtung AV nach der Erfindung realisiert sein.

In den Figuren ist der jeweilige Aktuator-Betätigungsabschnitt 11m, 12m, 13m der Aktuatoren 11, 12, 13 generell auch mit dem Bezugszeichen "M" und ein entgegen der Z-Richtung daran anschließender Aktuator-Anschlussabschnitt 11n, 12n, 13n mit jeweils einer elektrisch leitfähigen Aktuator-Anschlussschicht 31d, 32d, 33d und -je nach Ausführungsform - optional einem Aktuator-Stufenabschnitt 11n, 12n, 13n, generell auch mit dem Bezugszeichen "N" bezeichnet.

Die Aktuator-Anschlussschichten 31d, 32d, 33d weisen entlang in der Z-Richtung verlaufende Seitenflächenabschnitte 31p, 31q bzw. 32p, 32q bzw. 33p, 33q auf, wobei die jeweils zwei Seitenflächenabschnitte 31p und 32q bzw. 32p und 33q jeweils nächstliegend benachbarter Aktuatoren 11, 12, 13 einander zugewandt gelegen sind.

Bei dem Vorhandensein von Aktuator-Stufenabschnitten 11n, 12n, 13n weisen diese - in analoger Weise - entlang in der Z-Richtung verlaufende Seitenflächenabschnitte 11p, 11q bzw. 12p, 12q bzw. 13p, 13q auf, wobei die jeweils zwei Seitenflächenabschnitte 11p und 12q bzw. 12p und 13q jeweils nächstliegend benachbarter Aktuatoren 11, 12, 13 einander zugewandt gelegen sind.

Die Aktuator-Betätigungsabschnitte 11m, 12m, 13m des Grundkörpers 10 bzw. des Aufbaukörpers 10b erstrecken sich vom Basiskörper 10a in der Y-Richtung in eine Höhe hm, die bei den Aktuator-Betätigungsabschnitten 11m, 12m, 13m einer Aktuatorvorrichtung AV insbesondere gleich groß sein kann. In der Figur 1 ist auch beispielartig die Höhe h11a des Aktuator-Betätigungsabschnitts 11m eingetragen.

Weiterhin können die sich in der X-Richtung erstreckenden Breiten b1, b2, b3 und die sich in der Z-Richtung erstreckenden Längen oder Tiefen t0 der Aktuator-Betätigungsabschnitte 11m, 12m, 13m der erfindungsgemäßen Aktuatorvorrichtung AV insbesondere gleich groß sein.

Die sich in der Tiefenrichtung oder Z-Richtung erstreckenden jeweiligen Aktuator-Betätigungsabschnitte 11m, 12m, 13m sind aus einem piezoelektrischen oder elektrostriktiven Material gebildet und erstrecken sich mit ihrer jeweiligen Aktuator-Anschlussschicht 31d, 32d, 33d in der Dickenrichtung oder Y-Richtung von dem Basiskörper 10a unter Ausbildung einer zwischen jeweils zwei Aktuatoren 11, 12, 13 gelegenen Ausnehmung S0, S1, S2, S3. Die jeweilige Ausnehmung S0, S1, S2, S3 ist hierin wie folgt definiert:
- Derjenige Bereich einer jeweiligen zwischen jeweils zwei Aktuator-Betätigungsabschnitten 11m, 12m, 13m gelegenen Ausnehmung S0, S1, S2, S3, der in sich in der Z-Richtung über die Länge der jeweiligen Aktuatoren erstreckt, wird im Folgenden Betätigungsbereich-Teilabschnitt S0a, S1a, S2a, S3a genannt.
- Derjenige Bereich einer jeweiligen zwischen jeweils zwei Aktuatoren 11, 12, 13 gelegenen Ausnehmung S0, S1, S2, S3, der zwischen jeweils zwei benachbarten Aktuator-Anschlussschichten 31d, 32d, 33b gelegen ist und sich in der Z-Richtung über die Länge der jeweiligen Aktuator-Anschlussschichten 31d, 32d, 33b erstreckt, wird im Folgenden Anschlussbereich-Teilabschnitt S0b, S1b, S2b, S3b genannt.

In dem Fall, dass die Aktuatoren 11, 12, 13 äußere Betätigungs-Elektroden aufweisen, sind die an der Vorderseite 1 gelegenen und sich entgegen die Tiefenrichtung oder Z-Richtung weisenden Oberflächen 11c, 12c, 13c der Aktuator-Betätigungsabschnitte 11m, 12m, 13m jeweils mit einer Aktuator-Außenelektrodenschicht 31c, 32c, 33c beschichtet, die jeweils an eine Aktuator-Anschlussschicht 31d, 32d, 33b anschließt oder mit jeweils einer Aktuator-Anschlussschicht 31d, 32d, 33b elektrisch verbunden ist. In diesem Fall bilden die Aktuator-Außenelektrodenschichten 31c, 32c, 33c mit jeweils einer Aktuator-Anschlussschicht 31d, 32d, 33b eine jeweilige Aktuator-Betätigungsschicht 31a, 32a, 33a.

Die elektrisch leitfähigen Aktuator-Anschlussschichten 31d, 32d, 33d, die jeweils jeder der Aktuatoren 11, 12, 13 zur Verbindung mit Anschlusspolen einer elektrischen Erregervorrichtung aufweist, sind zumindest abschnittsweise gelegen:
(i) entweder auf einer in die Dickenrichtung oder Y-Richtung orientierten Oberfläche 10u des Basiskörpers 10a (Figuren 1, 3, 10), oder
(ii) auf einem an der Vorderseite 1 gelegenen und sich in Tiefenrichtung oder Z-Richtung an den jeweiligen Aktuator-Betätigungsabschnitt 11m, 12m, 13m anschließenden und von dem Basiskörpers 10a in der Y-Richtung abstehenden Aktuator-Stufenabschnitt 11n, 12n, 13n der Aktuatoren 11, 12, 13 (Figuren 6, 9, 11, 12, 13).

Somit werden die Anschlussbereich-Teilabschnitte S0b, S1b, S2b, S3b in der Z-Richtung, also im XY-Querschnitt gesehen begrenzt durch:
- einander gegenüberliegende zugewandte Seitenflächenabschnitte 31q bzw. 32p, 32q bzw. 33p der Aktuator-Anschlussschichten 31d, 32d, 33d jeweils von zueinander am nächsten benachbart gelegenen Aktuatoren 11 und 12 bzw. 12 und 13,
- je nach Ausführungsform gegebenenfalls durch einander zugewandten Seitenflächenabschnitte 11q bzw. 12p, 12q bzw. 13p von optional vorgesehenen einander nächstliegend benachbarten Aktuator-Stufenabschnitten 11n, 12n, 13n,
- den in die Dickenrichtung Y weisenden Oberflächenabschnitt 10u des Basiskörpers 10a und
- einer dem Oberflächenabschnitt 10u des Basiskörpers 10a zugewandten und der jeweiligen Ausnehmung S0, S1, S2, S3 zugewandten Oberfläche 100a der Leiterplatte 100.

Zwischen jeweils zwei benachbarten Aktuator-Anschlussschichten 31d, 32d, 33d ist somit jeweils ein Anschlussbereich-Teilabschnitt S0b, S1b, S2b, S3b der jeweiligen Ausnehmung S0, S1, S2, S3 gelegen. Die Aktuator-Anschlussschichten 31d, 32d, 33d sind jeweils elektrisch mit zumindest einer jeweils als Aktuator-Außenelektrodenschicht 31c, 32c, 33c ausgeführten Außen-Elektrode oder mit zumindest einer Innen-Elektrode des jeweiligen Aktuators 11, 12, 13 verbunden, die innerhalb der Aktuatoren 11, 12 13 zur elektrischen Anregung derselben angeordnet ist.

Die Aktuatorvorrichtung AV weist weiterhin eine Leiterplatte 100 auf, die sich in oder entlang der Längsrichtung X der Aktuatorvorrichtung AV über zumindest Abschnitte der Aktuator-Außenelektrodenschichten 31c, 32c, 33c erstreckt und deren Leiterbahnen mit den Aktuator-Außenelektrodenschichten 31c, 32c, 33c in elektrischem Kontakt stehen.

Erfindungsgemäß ist zumindest einer der Anschlussbereich-Teilabschnitte S0b, S1b, S2b, S3b der jeweiligen Ausnehmung S0, S1, S2, S3 zumindest abschnittsweise derart mit einem ausgehärteten Harz-Verstärkungsmaterial gefüllt, dass das Harz-Verstärkungsmaterial zumindest abschnittsweise einen den jeweiligen Anschlussbereich-Teilabschnitt S0b, S1b, S2b, S3b begrenzende und einander gegenüberliegende zugewandte Seitenflächenabschnitte 11p, 11q bzw. 12p, 12q bzw. 13p, 13q jeweils von zueinander benachbart gelegenen Aktuator-Anschlussschichten 31d, 32d, 33d, den in die Dickenrichtung Y weisenden Oberflächenabschnitt 10u des Basiskörpers 10a und der Anschluss-Oberfläche 100a der Leiterplatte 100 oder einen dem Oberflächenabschnitt 10u des Basiskörpers 10a zugewandten Anschluss-Oberfläche 100a, d.h. eine der Oberfläche der jeweiligen Ausnehmung S0, S1, S2, S3 zugewandten Abschnitt 114b der Leiterplatte 100 berührt, so dass die Leiterplatte 100 im Bereich des Anschlussbereich-Teilabschnitts S0b, S1b, S2b, S3b einer jeweiligen Ausnehmung durch das Harz-Verstärkungsmaterial unterstützt ist und die Leiterplatte 100 über das Harz-Verstärkungsmaterial zusätzlich an den Aktuator-Anschlussschichten 31d, 32d, 33d fixiert ist..

Es ist vorteilhaft, wenn sich das Harz-Verstärkungsmaterial auch in dem jeweiligen Bereich zwischen der Leiterplatte und dem durch diese überdeckten Abschnitt der entsprechenden Aktuator-Außenelektrodenschicht 31c, 32c, 33c befindet, so dass auch diese Bereiche dazu beitragen, die Leiterplatte an den Aktuator-Anschlussschichten zu fixieren. Hierbei ist die entsprechende Schicht des Harz-Verstärkungsmaterials zwischen der Leiterplatte und dem durch diese überdeckten Abschnitt der jeweiligen Aktuator-Außenelektrodenschicht so dünn, dass ein galvanischer und damit elektrisch leitfähiger Kontakt zwischen der Leiterplatte und der Aktuator-Außenelektrodenschicht gewährleistet ist.

Generell können an Rückseiten-Oberflächen 11r, 12r jeweils eine Rückseiten-Teilschicht 11w bzw. 12w an den Aktuatoren 11, 12 angeordnet sein, an denen durch die elektrische Erregervorrichtung eine Polung erzeugt wird, die der an der äußeren oder inneren Betätigungs-Elektroden der Aktuatoren 11, 12, 13 anliegenden Polung entgegen gesetzt ist, um die piezoelektrischen oder elektrostriktiven Effekte an bzw. in den Aktuatoren 11, 12, 13 zu erzeugen.

Die nach der Erfindung vorgesehene Leiterplatte 100 kann in unterschieldicher Weise gestaltet sein, sofern diese eine elektrische Verbindung zwischen den jeweiligen Aktuator-Anschlussschichten 31d, 32d, 33d und einem elektrischen Pol der elektrischen Anschlussvorrichtung bereitstellt. Die Leiterplatte 100 weist eine erste, entgegen die Y-Richtung, also zu den Aktuator-Anschlussschichten 31d, 32d weisende Oberfläche 100a, die den Aktuator-Anschlussbeschichtungen 31a, 32a zugewandt gelegen ist, und die entgegen gesetzt zu der ersten Oberfläche 100a gelegene zweite Oberfläche 100b auf,. Die Leiterplatte 100 ist aus einer Basisplatte 111 gebildet. Nach einer Ausführungsform der Leiterplatte 100 ist diese generell derart gestaltet, dass zumindest eine Leiterbahn an der zweiten Oberfläche 100b im Bereich der jeweiligen Oberflächen 31s, 32s austritt, um diese zu kontaktieren. Von der zweiten Oberfläche 100b ist der Bereich 100c eine den Anschlussbereich-Teilabschnitt S1b begrenzende Fläche.

Nach einer weiteren Ausführungsform der Leiterplatte 100 weist die Leiterplatte die Basisplatte 111 mit einer Kontaktierungs-Außenschicht 112 auf, die zumindest abschnittsweise auf einer ersten Oberfläche 111a der Basisplatte 111 gelegen ist. Die Basisplatte 111 weist eine zweite, entgegen gesetzt zu der ersten Oberfläche 111a gelegene zweite Oberfläche 111b auf, die in der dargestellten Ausführungsform die zweite Oberfläche 100b bildet. An der ersten Oberfläche 111a der Basisplatte 111 kann eine elektrisch leitfähige Kontaktierungs-Außenschicht 112 mit einer äußeren Oberfläche 112a angeordnet sein.

Bei der Ausführungsform der Figur 4 weist die Leiterplatte 100 eine Kontaktierungs-Zwischenschicht 113 auf, die auf der ersten Oberfläche 111a der Basisplatte 111 und zwischen der Basisplatte 111 kann eine elektrisch leitfähige Kontaktierungs-Außenschicht 112 gelegen ist. Der den Anschlussbereich-Teilabschnitt S1b begrenzende Bereich 100c wird bei dieser Ausführungsform durch die äußere Oberfläche 112a der Kontaktierungs-Außenschicht 112 gebildet.

Die erfindungsgemäßen Ausführungsformen der Aktuatorvorrichtungen AV können eine dieser Ausführungsformen der Leiterplatte 100 aufweisen.

Bei der Ausführungsform der Figur 1 sind jedoch vorzugsweise zwei Leiterbahnen v1, v2 vorgesehen, die an der zweiten Oberfläche 100b austreten, so dass die jeweils austretende zumindest eine Leiterbahn jeweils eine der Aktuator-Anschlussbeschichtungen 31a, 32a kontaktiert. Die Leiterplatte 100 ist zudem derart ausgebildet, dass deren Leiterbahnen - z.B. dadurch, dass diese an einem Anschlussabschnitt der Leiterplatte 100 aus dieser austreten - an eine elektrische Erregervorrichtung anschließbar ist, die Erregersignale erzeugt, mit der die Aktuatoren 11, 12, 13 zur Ausübung eines piezoelektrischen oder elektrostriktiven Effekts betätigt werden können.

Die Leiterplatte 100 kann zumindest eine weitere Leiterbahn X1 aufweisen, die elektrisch nicht an eine der Aktuator-Anschlussschichten 31d, 32d, 33d, jedoch an die Rückseitenschicht 4 oder die Rückseiten-Teilschichten 11w, 12w angeschlossen ist, so dass die elektrische Erregervorrichtung über die Aktuator-Anschlussschichten 31d, 32d, 33d und die Rückseitenschicht 4 oder die Rückseiten-Teilschichten 11w, 12w Betätigungselektroden, die an oder in jeweils einem Aktuatorkörper 11a, 12a, 13a angeordnet und voneinander beabstandet sind, mit unterschiedlicher Polung anzusteuern.

Die Aktuatorvorrichtung AV nach der Figur 1 weist einen Aufbaukörper 10b mit zwei Aktuatorkörpern 11a, 12a auf. Zur Ausbildung der Aktuatoren 11, 12 ist an der Vorderseite 1 jedes der Aktuatorkörper 11a, 12a eine Aktuator-Anschlussschicht 31d, 32d gelegen. Die Aktuatorvorrichtung AV nach der Figur 1 weist keinen Aktuator-Stufenabschnitt 11n, 12n, 13n auf.

An den Rückseiten-Oberflächen 11r, 12r der Aktuatoren 11 bzw. 12 sind jeweils eine Rückseiten-Teilschicht 11w bzw. 12w oder Anschlussschichtenangeordnet, an denen durch die elektrische Erregervorrichtung eine Polung erzeugt wird, die der an der Aktuator-Anschlussschicht 31d, 32d des jeweiligen Aktuators 11, 12 anliegenden Polung entgegen gesetzt ist, um den piezoelektrischen oder den elektrostriktiven Effekt in den Aktuatoren 11, 12 zu erzeugen.

Somit weist die Aktuator-Anschlussschicht 31d, 32d lediglich Betätigungs-Außenelektroden, nämlich die Anschlussschichten 11z, 12z und die Aktuator-Anschlussschichten 31d, 32d, auf.

Wie in der Figur 4 im Detail dargestellt, ist auf entlang der Y-Richtung orientierten Oberflächen 31s, 32s der Aktuator-Anschlussschichten 31c bzw. 32c die Leiterplatte 100 gelegen, wobei die Oberflächen 31s, 32s in galvanischem bzw. elektrischem Kontakt mit der Anschluss-Oberfläche 100a sind.

Der Anschlussbereich-Teilabschnitt S1b der Ausnehmung S1 ist weitgehend, also zumindest abschnittsweise derart mit einem ausgehärteten Harz-Verstärkungsmaterial M gefüllt, dass eine Verbindungsschicht V aus dem ausgehärteten Harz-Verstärkungsmaterial das Harz-Verstärkungsmaterial zumindest abschnittsweise den Anschlussbereich-Teilabschnitt S1b begrenzende und einander gegenüberliegende, also einander zugewandte Seitenflächen, den in die Dickenrichtung Y weisenden Oberflächenabschnitt 10u des Basiskörpers 10a und den dem Oberflächenabschnitt 10u des Basiskörpers 10a zugewandten Bereich 100c der Leiterplatte 100 berührt, so dass die Leiterplatte 100 im Bereich des Anschlussbereich-Teilabschnitts S0b, S1b, S2b, S3b einer jeweiligen Ausnehmung durch das Harz-Verstärkungsmaterial unterstützt ist und die Leiterplatte 100 über das Harz-Verstärkungsmaterial zusätzlich an den Aktuator-Anschlussschichten 31d, 32d, 33d fixiert ist..

In der Figur 5 ist eine Variante der in den Figuren 3 und 4 dargestellten Aktuatorvorrichtung dargestellt, bei der die Verbindungsschicht V in dem Anschlussbereich-Teilabschnitt S1b und zusätzlich jeweils als Verbindungs-Teilschicht V1, V2 zwischen jeweils einer der Aktuator-Anschlussbeschichtungen 31d bzw. 32d und der Leiterplatte 100 gelegen ist, um die Leiterplatte 100 über die Verbindungs-Teilschicht V1, V2 mit den Aktuator-Anschlussbeschichtungen 31d bzw. 32d zu verbinden.

In der Figur 6 ist eine weitere Ausführungsform der erfindungsgemäßen Aktuatorvorrichtung AV dargestellt, die sich von der Ausführungsform der erfindungsgemäßen Aktuatorvorrichtung AV nach der Figur 1 dadurch unterscheidet, dass die Aktuatoren 11, 12 jeweils einen Aktuator-Stufenabschnitt 11n, 12n aufweisen. Diese weisen entlang in der Z-Richtung verlaufende Seitenflächenabschnitte 11p, 11q bzw. 12p, 12q auf, wobei die jeweils zwei Seitenflächenabschnitte 11p und 12q bzw. 12p und 13q jeweils nächstliegend benachbarter Aktuatoren 11, 12 einander zugewandt gelegen sind.

Somit weist die Aktuator-Anschlussschicht 31d, 32d lediglich Betätigungs-Außenelektroden, nämlich die Anschlussschichten 11z, 12z und die Aktuator-Anschlussschichten 31d, 32d, auf.

In der Figur 9 ist eine weitere Ausführungsform der erfindungsgemäßen Aktuatorvorrichtung AV dargestellt, die sich von den Ausführungsformen der erfindungsgemäßen Aktuatorvorrichtung AV nach den Figuren 1 und 6 dadurch unterscheidet, dass jeder der Aktuatoren 11, 12 der Aktuatorvorrichtung AV lediglich zwei innere Betätigungselektroden E1, E2 aufweist, die in einem in den Aktuatorkörpern 11a, 12a voneinander beabstandet angeordnet sind. Bei der Aktuatorvorrichtung AV der Figur 9 ist die elektrische Erregervorrichtung über eine jeweilige mit dieser verbundenen Zufuhrleitung ZE2 an der inneren Betätigungselektrode E2 und über eine jeweilige Aktuator-Anschlussschicht 31d, 32d, 33d an der inneren Betätigungselektrode E1 angeschlossen.

Bei der Ausführungsform der Aktuatorvorrichtung AV nach der Figur 9 weisen die Aktuatoren 11, 12 jeweils einen Aktuator-Stufenabschnitt 11n, 12n auf.

In der Figur 10 ist eine weitere Ausführungsform der erfindungsgemäßen Aktuatorvorrichtung AV dargestellt, die sich von den Ausführungsformen der erfindungsgemäßen Aktuatorvorrichtung AV nach der Figur 9 dadurch unterscheidet, dass die Aktuatorvorrichtung AV keinen Aktuator-Stufenabschnitt 11n, 12n aufweist.

Wie es in den Figuren 5 und 8 dargestellt ist, kann vorgesehen sein, dass das Harz-Verstärkungsmaterial zusätzlich zwischen der jeweiligen Verlängerungs-Teilschicht 31d, 32d und der Leiterplatte 100 zur Fixierung der Leiterplatte 100 an der Verlängerungs-Teilschicht 31d, 32d angeordnet oder gelegen ist, wobei der zwischen diesen gelegene Teil des Verstärkungsmaterials oder die Verbindungs-Teilschicht VT1 bzw. VT2 mit dem Hauptteil VH des Verstärkungsmaterials verbunden ist, der in dem Anschlussbereich-Teilabschnitt S1b der jeweiligen Ausnehmung S1 gelegen ist.

Die Verbindungs-Teilschichten VT1 bzw. VT2 können beim oder nach dem Auflegen der Leiterplatte 100 auf die Aktuator-Anschlussschichten 31d, 32d, 33d entstehen, wenn bei einer entsprechenden, zuvor bestimmbaren Menge von Harz-Verstärkungsmaterial und dem Auflegen auf die Verlängerungs-Teilschicht ein Einfließen des Harz-Verstärkungsmaterials zusätzlich zwischen die jeweiligen Verlängerungs-Teilschichten und der Leiterplatte erfolgt, um die Leiterplatte an der Verlängerungs-Teilschicht zu fixieren. Dabei ist der zwischen diesen gelegene Teil der Verstärkungsmaterial mit dem Teil der Verstärkungsmaterial verbunden, der in dem Anschlussbereich-Teilabschnitt der jeweiligen Ausnehmung, die der Verlängerungs-Teilschicht begrenzt, gelegen ist. Dabei ist weiterhin eine Menge an Harz-Verstärkungsmaterial in den Anschlussbereich-Teilabschnitten S0b, S1b, S2b, S3b derart angeordnet ist, dass das Harz-Verstärkungsmaterial die die Anschlussbereich-Teilabschnitte S0b, S1b, S2b, S3b begrenzenden Oberflächen berührt.

Bei den Ausführungsformen der Aktuatorvorrichtung AV kann, wie bei der Aktuatorvorrichtung AV nach den Figuren 1 bis 8, vorgesehen sein, dass an den der Vorderseite 1 zugewandten Oberflächen 11c, 12c, 13c der Aktuatoren 11, 12 13 elektrisch leitfähige Vorderseitenbeschichtungen 31c, 32c, 33c als äußere Elektrode oder Außen-Elektrode der Aktuatoren 11, 12, 13 angeordnet sind, die in elektrischem Kontakt mit den Aktuator-Anschlussschichten 31d, 32d, 33d stehen, wobei die Vorderseitenbeschichtungen 31c, 32c, 33c elektrisch mit jeweils einer Aktuator-Außenelektrodenschicht 31c bzw. 32c bzw. 33c als äußere Elektrode oder Außen-Elektrode der Aktuatoren 11, 12, 13 verbunden sind. Jede der Vorderseitenbeschichtungen 31c, 32c, 33c und jeweils eine Rückseiten-Teilschicht 11w, 12w des jeweiligen Aktuators 11, 12, 13 können jeweils an zueinander gegensätzlichen elektrischen Polen der elektrischen Erregervorrichtung angeschlossen sein.

Bei den Ausführungsformen der Aktuatorvorrichtung AV kann, wie bei der Aktuatorvorrichtung AV nach den Figuren 9 und 10 gezeigt, vorgesehen sein, dass an den der Vorderseite 1 zugewandten Oberflächen 11c, 12c, 13c der Aktuatoren 11, 12 13 elektrisch leitfähige Vorderseitenbeschichtungen 31c, 32c, 33c angeordnet sind, die in elektrischem Kontakt über jeweils eine der Aktuator-Anschlussschichten 31d, 32d, 33d mit zumindest einer ersten inneren Elektrode oder ersten Innen-Elektrode E1 an der Vorderseite 1 in Verbindung stehen, wobei die Aktuatoren 11, 12, 13 jeweils zumindest eine zweite innere Elektrode oder Innen-Elektrode E2 aufweist. Generell kann dabei vorgesehen sein, dass die Aktuatoren 11, 12 jeweils zumindest eine erste und zumindest eine zweite innere Elektrode oder Innen-Elektrode E1 bzw. E2 aufweist, wobei sich die zumindest erste innere Elektrode E1 in positiver Tiefenrichtung oder Z-Richtung im jeweiligen Aktuator 11, 12 von der jeweiligen Stirnfläche 11c bzw. 12c bis zu einem Abstand a2 zu der Oberfläche 2a an der Rückseite 2 hin erstreckt, und wobei sich die zumindest zweite innere Elektrode E3 in negativer Tiefenrichtung oder Z-Richtung von der Rückseite 2 bis zu einem Abstand a1 zur jeweiligen Stirnfläche 11c bzw. 12c an der Vorderseite 1 hin erstreckt, wobei die erste Innen-Elektrode E1 elektrisch mit den Vorderseitenbeschichtungen verbunden sind und die zweiten Innen-Elektrode E2 elektrisch mit der jeweiligen Rückseiten-Teilschicht 11w bzw. 12w verbunden sind.

Generell können die Rückseiten-Teilschicht 11w bzw. 12w an der Rückseite 2a miteinander elektrisch verbunden ineinander übergehen oder voneinander separate Schichten sein. Im ersten Fall ist eine an der Rückseite 2 der Aktuatorvorrichtung AV eine kontinuierlich zusammenhängende, elektrisch leitfähige Rückseitenbeschichtung angeordnet, die sich in elektrischem Kontakt mit den zweiten Innen-Elektroden der Aktuatoren befindet.

Generell kann dabei vorgesehen sein, dass die Aktuatoren 11, 12 jeweils mindestens zwei erste und zweite Anregungs-Innen-Elektroden E1 bzw. E2 aufweisen (Figur 11).

Die Rückseiten-Teilschichten 11w, 12w können über externe Verbindungsvorrichtung und insbesondere externe Leitungen mit der elektrischen Anschlussvorrichtung verbunden sein. Nach einer weiteren in der Figur 1 schematisch dargestellten Ausführungsform ist in der Leiterplatte 100 zumindest eine an die elektrische Anschlussvorrichtung anschließbare Leiterbahn w1, w2 angeordnet, die mit einer Verbindungsleitung w3 bzw. w4 im Basisköper 10b verbunden ist. Dabei kann, wie es in der Figur 1 gezeigt ist, vorgesehen sein, dass die Verbindungsleitung w3 bzw. w4 durch die Aktuator-Anschlussschicht 31d, 32d, 33d isoliert zu dieser (nicht gezeigt) hindurchtritt und an ihrem diesbezüglichen Ende mit der jeweiligen Leiterbahn w1 bzw. w2 in Verbindung steht. Alternativ oder zusätzlich dazu kann vorgesehen sein, dass die Rückseiten-Teilschichten 11w, 12w können über interne, also innerhalb des Basisköpers 10b verlaufende Verbindungsvorrichtung und insbesondere interne Leitungen w5 bzw. w6 mit der elektrischen Anschlussvorrichtung verbunden sein. Diese können über Anschlussvorrichtungen w7 bzw. w8 und Verbindungsleitungen, die an diese jeweils angeschlossen sind, mit der elektrischen Anschlussvorrichtung verbunden sein. Falls bei diesen Ausführungsformen nur eine Rückseiten-Schicht oder zusammenhängende Rückseiten-Teilschichten 11w, 12w vorgesehen ist, kann nur eine Leitungen w5 oder w6 ausreichen.

Diese Merkmale und Kombinationen können erfindungsgemäß auch bei den an Hand der Figuren 11 bis 20 beschriebenen Ausführungsformen der Aktuatorvorrichtung AV vorgesehen sein.

Die Aktuatorvorrichtung AV nach der Figur 11 weist mehr als drei Aktuatoren auf, wobei sich die in der in der X-Richtung erstreckende Breite DS1, DS2 zwischen in der X-Richtung benachbart zueinander gelegenen Aktuatoren 11 und 12 bzw. 12 und 13 gleich groß ist. Die Aktuatorvorrichtung AV weist einen Rückführungskörper 21 auf. Zwischen dem Aktuator 11 und dem Rückführungskörper 21 eine Ausnehmung S0 mit der in der X-Richtung verlaufenden Breite DS0 mit einer in die Y-Richtung weisenden Oberfläche 40 angeordnet. Insbesondere kann vorgesehen sein, dass die Breiten DS1, DS2 zwischen jeweils zwei in der X-Richtung benachbart zueinander gelegenen Aktuatoren mit der Breite DS0 zwischen dem Rückführungskörper 21 und dem benachbarten Aktor 11 übereinstimmen.

Der Abschnitt des Grundkörpers 10, der in der Y-Richtung gesehen bis zu den in die Y-Richtung weisenden und die zugewandten Seiten AS1, AS2 jeweils verbindenden Oberflächen 40, 41, 42 der Ausnehmungen S0, S1, S2 reicht, bildet den Basiskörper 10a. In den Figuren ist beispielartig die Höhe h43 des Basiskörpers 10a der Ausnehmung S3 eingetragen, wobei die Höhen h43 bei den dargestellten Ausführungsformen gleich groß sind, jedoch generell auch unterschiedlich sein können.

Die Aktuatoren 11, 12, 13 können sich bei der erfindungsgemäßen Aktuatorvorrichtung AV aufgrund einer Betätigung durch die elektrische Betätigungsvorrichtung, d.h. durch Beaufschlagung mit einer elektrischen Spannung, in der Dickenrichtung Y ausdehnen oder zusammenziehen. Auf diese Weise können diese beispielsweise auf zu verstellende oder formveränderliche Teile oder Teilbereiche einer Anwendungskomponente einwirken.

Die erfindungsgemäße Aktuatorvorrichtung AV kann z.B. als Piezomotor ausgeführt sein. Daneben kann die erfindungsgemäße Aktuatorvorrichtung AV als Ultraschallwandler, insbesondere als Ultraschallarray oder Lineararray ausgeführt sein. Weiterhin kann in einem Anwendungsfall der Erfindung eine Anwendungskomponente eine Behältervorrichtung einer Druckmittel-Abgabevorrichtung eines Druckers und insbesondere eines Tintenstrahldruckers mit einer Mehrzahl von einzeln formveränderlichen Teilbehältern sein, so dass durch eine derart durch die erfindungsgemäß vorgesehenen Aktuatoren verursachte Formveränderung eines Teilbehälters in diesem enthaltende Druckmittels, wie im Beispiel des Tintenstrahldruckers Tinte, durch eine Düse desselben verdrängt werden kann. Eine andere Anwendungskomponente kann eine Einspritzvorrichtung eines Motors und die Teilbehälter Behälter zur Aufnahme und zum Ausspritzen von Treibstoff sein, das durch Aktuieren von erfindungsgemäß vorgesehenen und an den Teilbehältern anliegenden Aktuatoren bewirkt wird.

Die zuvor beschriebenen Anwendungen nutzen den sogenannten inversen piezoelektrischen Effekt, bei welchem durch Anlegen einer elektrischen Spannung eine Deformation des Aktuators oder Aktors hervorgerufen wird. Es ist jedoch ebenso denkbar, dass mit der erfindungsgemäßen Aktuatorvorrichtung der piezoelektrische Effekt genutzt wird, beispielsweise in Form eines Sensors. Bei Nutzung einer Vielzahl von Aktoren ist beispielsweise Sensor zur Positionsdetektierung vorstellbar.

Die Aktuatorvorrichtung AV weist weiterhin auf: eine Vorderseite 1, eine in Bezug auf eine Längsrichtung X der Aktuatorvorrichtung AV entgegengesetzt zu der Vorderseite 1 gelegene Rückseite 2, eine in negativer Y-Richtung weisende Unterseite SL sowie eine in positiver Y-Richtung weisende Oberseite SU. Die Vorderseite 1 ist in Längsrichtung X gesehen und in Bezug auf den Ort der Aktuatoren 11, 12, 13 auf einer Seite, die entgegen gesetzt zur Rückseite 2 gelegen ist, angeordnet. Somit ist die Vorderseite 1 in Bezug auf die Aktuatoren 11, 12, 13 jenseits der Rückseite 2 angeordnet. Die Rückseite 2 des Grundkörpers 10 ist aus einer Oberfläche 2a gebildet, die eine einheitliche und insbesondere ebene Oberfläche darstellt. Unter "einheitlich" wird in diesem Zusammenhang verstanden, dass sich die Oberfläche entlang der X-Richtung erstreckt. Insbesondere kann dabei vorgesehen sein, dass die Oberfläche 2a eine über ihre Erstreckung einheitliche Krümmung aufweist, also keinen Wendepunkt besitzt.

Der Grundkörper 10 weist einen Basiskörper 10a und einen Aufbaukörper 10b mit sich in der Dickenrichtung Y von dem Basiskörper 10a aus erstreckenden AktuatorKörpern 11a, 12a, 13a auf, aus denen die Aktuatoren 11, 12, 13 gebildet sind. Die Aktuator-Körper 11a, 12a, 13a sind aus einem piezoelektrischen oder elektrostriktiven Material und beispielsweise aus PZT gebildet und zumindest in einigen derselben sind Betätigungs-Elektroden angeordnet, die durch eine Betätigungsvorrichtung betätigbar sind. Die jeweiligen Aktuatorkörper 11a, 12a, 13a mit den jeweils in diesen angeordneten Betätigungs-Elektroden bilden jeweils einen Aktuator 11, 12, 13. Jeder Aktuatorkörper 11a, 12a, 13a weist eine obere Oberfläche 11e bzw. 12e bzw. 13e auf, die somit Teil der Oberseite SU sind.

Die sich in der X-Richtung erstreckenden Breiten b und die sich in der Z-Richtung erstreckenden Längen oder Tiefen t0 der Aktuatorkörper 11a, 12a, 13a der erfindungsgemäßen Aktuatorvorrichtung AV können insbesondere gleich groß sein.

In den dargestellten Ausführungsformen der erfindungsgemäßen Aktuatorvorrichtung AV sind die Aktuatoren 11, 12, 13 nebeneinander bzw. in X-Richtung hintereinander derart angeordnet, dass zwischen jeweils zwei Aktuatoren - beispielsweise zwischen den Aktuatoren 11, 12, 13 - eine Ausnehmung S1, S2 mit der sich in der in der X-Richtung erstreckenden Breite DS1 bzw. DS2 und den in die Y-Richtung weisenden Oberflächen 41, 42 ausgebildet ist. Die Ausnehmungen S1 und S2 werden somit umgrenzt von der Oberfläche 41 bzw. 42 und den einander zugewandten Seiten AS1, AS2 jeweils benachbarter Aktuatoren 11 und 12 bzw. 12 und 13. Die sich in der in der X-Richtung erstreckende Breite (z.B. DS1, DS2) zwischen in der X-Richtung benachbart zueinander gelegenen Aktuatoren (z.B. Aktuatoren 11 und 12) kann insbesondere gleich groß sein. Alternativ können auch unterschiedliche Breiten vorgesehen sein. Auch ist zwischen dem Aktuator 11 und dem Rückführungskörper 21 eine Ausnehmung S0 mit der in der X-Richtung verlaufenden Breite DS0 mit einer in die Y-Richtung weisenden Oberfläche 40 angeordnet. Insbesondere kann vorgesehen sein, dass die Breiten DS1, DS2 zwischen jeweils zwei in der X-Richtung benachbart zueinander gelegenen Aktuatoren mit der Breite DS0 zwischen dem Rückführungskörper 21 und dem benachbarten Aktor 11 übereinstimmen.

Der Abschnitt des Grundkörpers 10, welcher in der Y-Richtung gesehen bis zu den Oberflächen 40, 41, 42 der Ausnehmungen S0, S1, S2 reicht, bildet den Basiskörper 10a. In der Figur 1 ist beispielartig die Höhe h43 der Ausnehmung S3 eingetragen. Demnach hat der Basiskörper 10a hier die Höhe h43.

Vorzugsweise ist vorgesehen, dass der Grundkörper 10 als Block gebildet ist, so dass der Grundkörper 10 einheitlich aus einem Basismaterial gebildet ist. Dabei kann auch vorgesehen sein, dass die Außenkontur, die aus den Außenflächen des Grundkörpers 10 gebildet ist, eine Quaderform hat. Die virtuelle Oberseite des Grundkörpers 10 ist teils aus den Oberflächen 40, 41, 42 und den zwischen diesen gelegenen und diese verbindenden virtuellen Verbindungsflächen gebildet. Die virtuellen Verbindungsflächen können insbesondere derart definiert sein, dass diese zwischen den Oberflächen 40, 41, 42 über die gesamte jeweilige Verbindungsfläche gesehen eine möglichst geringe Wölbung aufweisen. Die Aktuatoren 11, 12, 13 sind vorzugsweise einstückig mit dem Grundkörper 10 verbunden, so dass diese in ihrem jeweiligen Verbindungsbereich zu dem Grundkörper 10 flächig und fest mit diesem verbunden sind, so dass weder der Aktuator 11, 12, 13 insgesamt noch ein Teilabschnitt des jeweiligen Aktuators 11, 12, 13 eine Bewegungsfreiheit gegenüber dem Grundkörper 10 besitzt.

Die Aktuatorkörper 11a, 12a, 13a des Grundkörpers 10 bzw. des Aufbaukörpers 10b erstrecken sich vom Basiskörper 10a in der Y-Richtung in eine Höhe, die insbesondere für die Aktuatorkörper 11a, 12a, 13a der erfindungsgemäßen Aktuatorvorrichtung AV gleich groß ist. In der Figur 1 ist beispielartig die Höhe h13a des Aktuatorkörpers 13a eingetragen.

Die Aktuatoren 11, 12, 13 weisen jeweils zumindest zwei innere Betätigungs-Elektroden auf, die in einer Mehrzahl der Aktuatoren angeordnet sind und von denen sich zumindest eine erste innere Betätigungs-Elektrode E1, E3 von der Vorderseite 1 bis zu einem Abstand a2 zu der Rückseite 2 der Aktuatorvorrichtung AV hin erstreckt und von denen sich zumindest eine zweite innere Betätigungs-Elektrode E2, E4 von der Rückseite 2 bis zu einem Abstand a1 zur Vorderseite 1 hin erstreckt. Bei elektrischer Ansteuerung der zumindest einen ersten inneren Betätigungs-Elektrode E1, E3 und der zumindest einen zweiten inneren Betätigungs-Elektrode E2, E4 mit einer zueinander entgegen gesetzten elektrischen Polung durch eine an die Betätigungs-Elektroden angeschlossene Betätigungsvorrichtung wird eine Ausdehnung oder ein Zusammenziehen des zwischen den beiden Elektroden angeordneten piezoelektrischen oder elektrostriktiven Materials und damit des Aktuators in der Y-Richtung bewirkt, in dem diese gelegen sind.

Die Oberfläche einer Ausführungsform der erfindungsgemäßen Aktuatorvorrichtung AV, die in die Y-Richtung weist, kann im Bereich der Aktuatoren 11, 12, 13 ohne eine elektrisch leitende Schicht versehen sein, wie dies in der Figur 1 dargestellt ist. Bei dieser Ausführungsform sind sowohl die Oberflächen 11e, 12e, 13e, als auch die in die X-Richtung weisenden Seitenwände der Aktuatoren 11, 12, 13 und die Oberflächen 41, 42 der Ausnehmungen S2, S3 unbeschichtet.

Die Betätigungsvorrichtung ist mit einem ersten elektrischen Pol an die ersten Elektroden E1, E3 an der Vorderseite 1 anschließbar. Hierzu kann jeder anzusteuernde Aktuator 11, 12, 13 eine Direktanschluss-Beschichtung oder erste Anschluss-Schicht oder Aktuator-Anschlussbeschichtung 31a, 32a, 33a aus einem elektrisch leitenden und insbesondere metallischen Material aufweisen, die elektrisch mit den ersten inneren Betätigungs-Elektroden E1, E3 in Verbindung stehen und insbesondere direkt mit diesen verbunden sein können und dadurch den ersten Pol oder die ersten Pole der Aktuatorvorrichtung AV ausbilden. Die Aktuator-Anschlussbeschichtung 31a, 32a, 33a ist insbesondere aus einer Schicht 31c, 32c, 33c aus einem elektrisch leitenden und insbesondere metallischen Material gebildet, die auf der in die negative Z-Richtung weisenden Seitenfläche oder Stirnfläche 11c, 12c, 13c des jeweiligen Aktuators 11, 12, 13 gelegen ist. Die Schicht 31c, 32c, 33c steht elektrisch mit den ersten inneren Betätigungs-Elektroden E1, E3 in Verbindung und ist insbesondere direkt mit diesen verbunden.

In den dargestellten Ausführungsformen der Aktuatorvorrichtung AV weist jeder Aktuatorkörper 11a, 12a, 13a eine Stufe oder ein sich in der Z-Richtung erstreckendes zungenförmiges Anschlussstück oder eine zungenförmige Verlängerung 11b, 12b, 13b auf, so dass der Aktuatorkörper 11a, 12a, 13a jeweils aus einem Aktuatorkörper-Betätigungsstück B und einem Anschlussstück 11b, 12b, 13b mit der in der Z-Richtung verlaufenden Tiefe oder Länge t30 gebildet ist. Die Anschlussstücke 11b, 12b, 13b sind an ihrer in die Y-Richtung weisenden Oberfläche jeweils mit einer Aktuator-Anschlussbeschichtung 31a, 32a, 33a aus einem elektrisch leitenden und insbesondere metallischen Material beschichtet. Bei dieser Ausführungsform ist somit die Aktuator-Anschlussbeschichtung 31a, 32a, 33a durch die auf der jeweiligen Seitenfläche des Aktuatorkörper-Betätigungsstücks B gelegenen Teilschicht oder Betätigungsstück-Anschlussschicht 31c, 32c, 33c mit der Dicke d31c, d32c, d33c und der auf der zungenförmigen Verlängerung 31b, 32b, 33b gelegenen Aktuatoranschluss-Beschichtung mit der Dicke d31b, d32b, d33b gebildet. Weiterhin ist die auf der in die negative Z-Richtung weisenden Seitenfläche 11c, 12c, 13c des jeweiligen Aktuators 11, 12, 13 gelegene Teilschicht 31c, 32c, 33c mit der Betätigungsstück-Anschlussschicht 31c, 32c, 33c verbunden und kann insbesondere mit der Betätigungsstück-Anschlussschicht 31c, 32c, 33c einstückig ausgebildet sein, um eine einheitliche erste Anschluss-Beschichtung 31a, 32a, 33a zu bilden. Auf diese Weise kann der jeweilige erste Pol der Betätigungsvorrichtung an der Aktuator-Anschlussbeschichtung 31a, 32a, 33a angeschlossen werden.

Bei einer weiteren Ausführungsform der erfindungsgemäßen Aktuatorvorrichtung AV kann diese generell auch derart ausgeführt sein, dass diese kein zungenförmiges Anschlussstück oder keine zungenförmige Verlängerung 11b, 12b, 13b mit einer jeweiligen Aktuator-Anschlussbeschichtung 31a, 32a, 33a aufweist, so dass die Teilschichten oder Betätigungsstück-Anschlussschichten 31c, 32c, 33c die elektrischen Anschlüsse für die Betätigungsvorrichtung oder den ersten Pol bilden

Die erfindungsgemäße Aktuatorvorrichtung AV weist ein Rückführungs-Teilstück 20 zur Ausbildung eines zweiten elektrischen Pols auf. Das Rückführungs-Teilstück 20 weist den Rückführungskörper 21 und weiterhin einen Rückführungsabschnitt 26 mit einer in die negative X-Richtung weisenden Rückführungsabschnitt-Oberfläche 26a und einen sich in der Y-Richtung von diesem aus erstreckenden Stützabschnitt 25 auf. In der Y-Richtung gesehen hat der Rückführungsabschnitt 26 eine Höhe h26 und der Stützabschnitt 25 eine Höhe h25, so dass bei der Ausführungsform der Figur 1 der Rückführungskörper 21 eine Höhe h21 = h26 + h25 hat.

Bei einer Ausführungsform der erfindungsgemäßen Aktuatorvorrichtung AV sind die Aktuatorkörper 11a, 12a, 13a in der Längsrichtung oder der x-Richtung gesehen hintereinander gelegen und ist der Rückführungskörper 21 in der x-Richtung gesehen hinter der Reihe von Aktuatorkörpern 11a, 12a, 13a gelegen. Dabei kann insbesondere vorgesehen sein, dass die Oberfläche 26r des Rückführungskörpers 21 und die Oberfläche 2a der Rückseite 2 des Grundkörpers 10 eine einheitliche und insbesondere ebene Oberfläche bildet. Unter "einheitlich" wird in diesem Zusammenhang verstanden, dass sich die Oberfläche entlang der X-Richtung erstreckt. Insbesondere kann dabei vorgesehen sein, dass die Oberfläche eine über ihre Erstreckung einheitliche Krümmung aufweist, also keinen Wendepunkt besitzt.

Der Oberflächen-Bereich, mit dem der Rückführungsabschnitt 26 an der Rückseite 2 auftritt, ist mit dem Bezugzeichen 26r versehen.

In der Figur 1a ist eine Ausführungsform der erfindungsgemäßen Aktuatorvorrichtung AV gezeigt, die jeweils an ihren in X-Richtung gesehen gegenüberliegenden Stirnseiten SF1, SF2 ein Rückführungs-Teilstück 20-1, 20-2 aufweist. In den weiteren Figuren ist ein Rückführungs-Teilstück generell mit dem Bezugszeichen 20 bezeichnet und dessen hierin beschriebenen Ausführungsformen können an jeder der Stirnseiten SF1, SF2 angeordnet sein. Die Rückführungs-Teilstücke 20-1 bzw. 20-2 können nach einer der hierin genannten Ausführungsformen und insbesondere identisch gestaltet sein. In der Darstellung der Figur 1a sind die Aktuatoren schematisch als einzelne Striche eingetragen, die summarisch mit dem Bezugszeichen 11i versehen sind.

Die X-Koordinate des hierin verwendeten Koordinatensystems kann insbesondere derart definiert sein, dass der Ursprung des Koordinatensystems in dem Mittelpunkt des Kantenabschnitts liegt, der die Rückführungsabschnitt-Oberfläche 26a und die Unterseite SL miteinander verbindet. Die X-Koordinate verläuft dabei quer zur Längserstreckung der Aktuatoren 11, 12, 13, die sich von der Vorderseite 1 zur Rückseite 2 erstrecken, und durch den Mittelpunkt eines die Unterseite SL in der positiven X-Richtung abschließenden Kantenabschnitts, der insbesondere derjenige Kantenabschnitt sein kann, der eine Oberfläche, die in Bezug auf die Y-Richtung entgegen gesetzt zu der Rückführungsabschnitt-Oberfläche 26a weist und an der Unterseite SL anliegt, mit der Unterseite SL verbindet. Zur Definition des Koordinatensystems verläuft die Z-Achse durch die beiden vorderen, also an der Rückführungsabschnitt-Oberfläche 26a gelegenen unteren Eckpunkte Z1, Z2 der Aktuatorvorrichtung AV. Dabei ist der Punkt Z1 als Schnittpunkt der Unterseite SL, der Rückführungsabschnitt-Oberfläche 26a und der Vorderseite 1 und der Punkt Z2 als Schnittpunkt der Unterseite SL, der Rückführungsabschnitt-Oberfläche 26a und der Rückseite 2 definiert.

Bei dem genannten Kantenabschnitt oder den Punkten Z1, Z2 können ein idealisierter Kantenabschnitt oder können idealisierte Punkte verwendet werden, wenn bei einer Ausführung oder Realisierung der erfindungsgemäßen Aktuatorvorrichtung AV an den Stellen, an denen der Kantenabschnitt oder die Punkte angenommen werden, ein gerundeter Übergangsabschnitt bzw. jeweils eine abgerundete Ecke vorliegt. In diesem Fall ist nach der hierin gegebenen Definition vorgesehen, dass der Kantenabschnitt oder die Punkte zur Definition der Lage des Koordinatensystems an der Aktuatorvorrichtung AV durch Verlängerung der Erstreckung der jeweils dafür verwendeten Oberflächen oder Seiten gebildet wird bzw. werden, also gegebenenfalls der Rückführungsabschnitt-Oberfläche 26a, der Vorderseite 1, der Unterseite SL, der Rückführungsabschnitt-Oberfläche 26a oder der Rückseite 2.

Hierin kann bei entsprechenden gerundeten Oberflächenbereichen generell zur Definition einer Kantenlinie oder eines Punkte eine idealisierte Kantenlinie bzw. ein idealisierter Punkt verwendet werden, die aus dem Schnittpunkt von Verlängerungen der Erstreckung von zwei jeweiligen benachbarten und aufeinander zu verlaufenden Oberflächen entsteht bzw. entstehen. Unter Erstreckung kann hierbei eine Länge von 1/10 der Länge verstanden werden, über die sich die jeweilige Fläche in der jeweils relevanten und diese definierenden Richtung erstreckt.

Die in die Y-Richtung weisende Oberfläche 21a des Rückführungskörpers 21 ist bei der Ausführungsform der Figur 1 unbeschichtet, so dass die Oberfläche 21a des Rückführungskörpers 21 identisch mit der Oberfläche 21a des Rückführungs-Teilstücks 20 ist.

Alternativ oder zusätzlich zur Beschichtung der in die negative X-Richtung weisenden Rückführungsabschnitt-Oberfläche 26a kann generell bei den Ausführungsformen der erfindungsgemäßen Aktuatorvorrichtung AV auch die in die positive X-Richtung weisende und dem Aktuator 11 zugewandte Rückführungsabschnitt-Oberfläche 26b mit einer elektrisch leitfähigen Schicht beschichtet sein.

Der Rückführungsabschnitt 26 kann ein Rückführungs-Zusatzstück oder Rückführungs-Anschlussstück 23 aufweisen, das insbesondere als Stützabschnitt ausgeführt sein kann und in der negativen Z-Richtung gesehen im Bereich der Anschlussstücke 11b, 12b, 13b gelegen ist. Das Rückführungs-Anschlussstück 23 erhebt sich in der Y-Richtung gesehen um die Höhe h23 über die Oberfläche 40. Bei den Ausführungsformen der erfindungsgemäßen Aktuatorvorrichtung AV kann generell vorgesehen sein, dass das Anschlussstück 23 an seiner in der positiven Y-Richtung weisenden Oberfläche 23d mit einer elektrisch leitenden und insbesondere metallischen Rückführungs-Anschlussbeschichtung oder äußeren Anschlussschicht 23a mit der Dicke d23a beschichtet ist, der einen zweiten elektrischen Pol zum Anschluss der Betätigungsvorrichtung bildet.

Die Rückseite 2 des Grundkörpers 10 ist mit einer Rückseiten-Schicht 4 aus einem elektrisch leitenden und insbesondere metallischen Material beschichtet. Die Dicke der Rückseiten-Schicht 4 kann in der X-Richtung und in der Z-Richtung konstant sein. Auch kann generell bei den Ausführungsformen der erfindungsgemäßen Aktuatorvorrichtung AV vorgesehen sein, dass die Dicke d4b der Rückseitenschicht 4 im Bereich des Basiskörpers 10a bzw. im Bereich des Basiskörpers 10a, der an die Unterseite SL grenzt größer ist als die Dicke d4a der Rückseitenschicht 4 im Bereich des Aufbaukörpers 10b bzw. im Bereich des Aufbaukörpers 10b, der an die Oberseite SU grenzt, wobei insbesondere vorgesehen sein kann, dass die Dicke d4b um den Faktor 1,5 größer ist als die Dicke d4a.

Die Rückseiten-Schicht 4 steht elektrisch mit den zweiten inneren Betätigungs-Elektroden E2, E4 der Aktuatorvorrichtung AV in Verbindung und ist insbesondere direkt mit diesen verbunden. Die Rückseiten-Schicht 4 ist mit einer Rückführungs-Außenschicht 5 elektrisch verbunden und insbesondere einstückig mit dieser ausgebildet, wobei die Rückführungs-Außenschicht 5 ihrerseits mit der Rückführungsanschlussbeschichtung 23a verbunden und insbesondere einstückig mit dieser ausgebildet sein kann.

In der Ausführungsform der Figur 1 ist die Rückführungs-Außenschicht 5 aus einem Stirnseiten-Schichtabschnitt 24mit einer Oberfläche 24a gebildet, die elektrisch mit einem Rückseiten-Schichtabschnitt 22 als Abschnitt der Rückseiten-Schicht 4 verbunden ist. Die Dicke des Stirnseiten-Schichtabschnitts 24 kann in der Y-Richtung und in der Z-Richtung konstant sein. Auch kann generell bei den Ausführungsformen der erfindungsgemäßen Aktuatorvorrichtung AV vorgesehen sein, dass die Dicke d24b an bzw. im Bereich der Unterseite größer ist als die Dicke d24a des Stirnseiten-Schichtabschnitts 24 an bzw. im Bereich der Oberseite SU, wobei insbesondere vorgesehen sein kann, dass die Dicke d24b um den Faktor 1,5 größer als die Dicke d24a ist.

Um die vorgesehenen Aktuatoren 11, 12, 13 oder einige der Aktuatoren 11, 12, 13 separat anzusteuern, kann die elektrische Betätigungsvorrichtung mehrere erste elektrische Pole aufweisen und die Betätigungsvorrichtung derart eingerichtet sein, dass diese für jeden der ersten elektrischen Pole unterschiedliche Steuerspannungen bzw. Steuerströme erzeugen kann, so dass bei dieser Ausführungsform die Betätigungsvorrichtung die Aktuatoren 11, 12, 13 einzeln bzw. unterschiedlich betätigen kann. Nach einer weiteren Ausführungsform kann vorgesehen sein, dass sämtliche Aktuatoren 11, 12, 13 oder einige Aktuatoren 11, 12, 13 der Betätigungsvorrichtung AV jeweils an einem einzigen ersten elektrischen Pol angeschlossen sind, so dass diese in derselben Weise betätigt werden können.

Der zweite Pol der Betätigungsvorrichtung ist ebenfalls an der Vorderseite 1 der Aktuatorvorrichtung AV und bei der Ausführungsform gemäß Figur 1 an der Rückführungsanschlussbeschichtung 23a anschließbar bzw. angeschlossen. Hierzu weist die erfindungsgemäße Aktuatorvorrichtung AV eine äußere Verbindungsschicht oder Rückführungs-Verbindungsschicht 5 auf, die mit der Rückseiten-Schicht 4 vorzugsweise einstückig elektrisch verbunden ist.

Der Rückführungskörper 21 kann auch lediglich auch aus dem Rückführungsabschnitt 26 als Bestandteil des Basisabschnitts 10a bestehen, so dass dieser keinen in der Y-Richtung aufgesetzten Stützabschnitt 25 aufweist (Figuren 19 bis 30), so dass der Rückführungskörper 21 eine Höhe h21 = h26 hat.

Der Rückführungskörper 21 kann je nach dem Herstellungsverfahren zur Herstellung des Grundkörpers 10 oder der Aktuatorvorrichtung AV mit einem Aktuatorbereich 9 des Grundkörpers 10 einstückig und insgesamt als monolithischer Block ausgebildet sein. Alternativ dazu kann der Rückführungskörper 21 nach einem alternativen Herstellungsverfahren zur Herstellung des Grundkörpers 10 oder der Aktuatorvorrichtung AV mit dem Aktuatorbereich 9 als separates Stück ausgeführt sein, dass an dem Aktuatorbereich 9 angeklebt ist. Für diesen Fall ist schematisch in der Darstellung der Figuren 1 und 2 eine Klebeschicht 50 eingetragen.

Je nach der Ausführungsform des Rückführungskörpers 21 kann die Klebeschicht 50 auch an einer anderen Stelle und insbesondere in der X-Richtung gegenüber der in der Figur 1 gezeigten Stelle verschoben sein. Dabei kann der Rückführungskörper 21 auch einen Teil des sich in der Y-Richtung erstreckenden Bereichs des Grundkörpers 10 ausbilden, in dem die Ausnehmung 40 gelegen ist, so dass die Klebeschicht 50 in der X-Richtung gesehen im Bereich der Ausnehmung 40 gelegen ist. Auch kann die Klebeschicht 50 schräg verlaufen und dabei z.B. in einem spitzen Winkel zur Y-Achse und entlang der Z-Richtung verlaufen.

Bei der Ausbildung des Rückführungskörpers 21 aus dem Rückführungsabschnitt 26 und dem Stützabschnitt 25 kann insbesondere vorgesehen sein, dass die Oberseite 21a des Rückführungskörpers 21 in der Y-Richtung gesehen auf derselben Höhe wie die Aktuatorkörperoberflächen 11e, 12e, 13e der Aktuatoren 11, 12, 13 liegen, dass also h0 =h21 ist, so dass auf die Oberseite SU der erfindungsgemäßen Aktuatorvorrichtung AV und somit auf die Aktuatoren 11, 12, 13 oder die Aktuatorkörper 11a, 12a, 13a sowie auf die Oberfläche 21a eine formveränderliche Anwendungskomponente aufgelegt werden kann. Bei dieser Ausführungsform der erfindungsgemäßen Aktuatorvorrichtung hat der Rückführungskörper 21 mit dem Stützabschnitt 25 zusätzlich zur Funktion der Strom-Rückführung über die Rückführungs-Verbindungsschicht 5 eine Abstützfunktion, indem der Stützabschnitt 25 einen entsprechenden Abschnitt einer solchen Anwendungskomponente aufnimmt und lagert. Für diesen Fall kann insbesondere vorgesehen sein, dass - wie in der Figur 1 gezeigt - die Oberseite 21a desselben nicht mit einem elektrisch leitfähigen Material beschichtet ist. Bei der Ausführung nach der Figur 1 ist die Rückführungs-Verbindungsschicht 5 aus einem Schicht-Abschnitt 22 an der Rückseite 2 und einem Schicht-Abschnitt 24 an der ersten Stirnseite SF1 gebildet, die wiederum mit der Rückführungs-Anschlussbeschichtung 23a verbunden ist. Diese Schichten sind aus einem elektrisch leitfähigen Material gebildet. Auf diese Weise ist ein besonders effektiver Stromfluss bei einer einfachen und günstigen Herstellungsweise der erfindungsgemäßen Aktuatorvorrichtung AV sichergestellt.

Bei den Ausführungsformen der erfindungsgemäßen Aktuatorvorrichtung AV kann generell vorgesehen sein, dass an der in die negative X-Richtung weisenden Stirnseite SF1 das Rückführungs-Teilstück 20 ausgebildet ist. An einer in die positive X-Richtung weisenden Stirnseite (nicht gezeigt) der erfindungsgemäßen Aktuatorvorrichtung AV kann ebenfalls ein Rückführungs-Teilstück 20 nach einer hierin beschriebenen Ausführungsform derselben ausgebildet sein, die identisch oder unterschiedlich zu dem an der gegenüberliegenden Stirnseite gelegenen Rückführungs-Teilstück 20 ausgeführt sein kann. Alternativ dazu kann an der in die positive X-Richtung weisenden Stirnseite (nicht gezeigt) der erfindungsgemäßen Aktuatorvorrichtung AV ein Aktuator gelegen sein.

Wie es in den Figuren 16 und 20 dargestellt ist, kann vorgesehen sein, dass das Harz-Verstärkungsmaterial zusätzlich zwischen der jeweiligen Aktuator-Anschlussschicht oder Verlängerungs-Teilschicht 31d, 32d, 33d und der Leiterplatte 100 zur Fixierung der Leiterplatte 100 an der jeweiligen Verlängerungs-Teilschicht 31d, 32d, 33d angeordnet oder gelegen ist, wobei der zwischen diesen gelegene Teil des Verstärkungsmaterials oder die Verbindungs-Teilschicht VT0 bzw. VT1 bzw. VT2 mit dem jeweils in der X-Richtung neben diesem jeweils gelegene Hauptteil VH1 bzw. VH2 bzw. VH3 des Verstärkungsmaterials verbunden ist, der in dem Anschlussbereich-Teilabschnitt S1b der jeweiligen Ausnehmung S1 gelegen ist.

Die Verbindungs-Teilschichten VT1 bzw. VT2 können beim oder nach dem Auflegen der Leiterplatte 100 auf die Aktuator-Anschlussschichten 31d, 32d, 33d entstehen, wenn bei einer entsprechenden, zuvor bestimmbaren Menge von Harz-Verstärkungsmaterial und dem Auflegen auf die Verlängerungs-Teilschicht ein Einfließen des Harz-Verstärkungsmaterials zusätzlich zwischen die jeweiligen Verlängerungs-Teilschichten und der Leiterplatte erfolgt, um die Leiterplatte an der Verlängerungs-Teilschicht zu fixieren. Dabei ist der zwischen diesen gelegene Teil der Verstärkungsmaterial mit dem Teil der Verstärkungsmaterial verbunden, der in dem Anschlussbereich-Teilabschnitt der jeweiligen Ausnehmung, die der Verlängerungs-Teilschicht begrenzt, gelegen ist. Dabei ist weiterhin eine Menge an Harz-Verstärkungsmaterial in den Anschlussbereich-Teilabschnitten S0b, S1b, S2b, S3b derart angeordnet ist, dass das Harz-Verstärkungsmaterial die die Anschlussbereich-Teilabschnitte S0b, S1b, S2b, S3b begrenzenden Oberflächen berührt.

In diesem Fall und bei Vorhandensein eines Rückführungskörpers 21 kann die Verbindungs-Teilschicht VT0 zwischen einer Rückführungs-Anschlussbeschichtung 23a, die mit der Rückseitenschicht 4 elektrisch in Verbindung steht, und der Leiterplatte 100 optional vorgesehen sein. In diesem Fall können die Aktuator-Anschlussschichten oder Verlängerungs-Teilschichten 31d, 32d, 33d und die Rückführungs-Anschlussbeschichtung 23a jeweils an zueinander gegensätzlichen elektrischen Polen der elektrischen Erregervorrichtung angeschlossen sein.

## Patentansprüche

1. Aktuatorvorrichtung (AV), aufweisend:
- einen Grundkörper (10) mit einem Basiskörper (10a) und einem sich in einer Dickenrichtung (Y) von dem Basiskörper (10a) erstreckenden Aufbaukörper (10b),
- eine Mehrzahl von den Aufbaukörper (10b) bildenden und sich jeweils in einer Tiefenrichtung (Z) erstreckenden und aus einem Aktuatorkörper (11a, 12a, 13a) aus einem piezoelektrischen oder elektrostriktiven Material und an oder in diesem angeordneten und voneinander beabstandeten Betätigungselektroden gebildete Aktuatoren (11, 12, 13), wobei die Aktuatoren (11, 12, 13) in der Längsrichtung (X) der Aktuatorvorrichtung (AV) hintereinander angeordnet sind, wobei zwischen jeweils zwei benachbarten Aktuatoren ein Betätigungsbereich-Teilabschnitt (S0a, S1a, S2a, S3a) einer Ausnehmung (S0, S1, S2, S3) ausgebildet ist,
wobei die Aktuatoren (11, 12, 13) elektrisch leitfähige Aktuator-Anschlussschichten (31d, 32d, 33d) aufweisen, die mit den Betätigungselektroden der Aktuatoren (11, 12, 13) elektrisch in Verbindung stehen, wobei die Aktuator-Anschlussschichten (31d, 32d, 33d) zumindest abschnittsweise gelegen sind
(i) entweder auf einer in die Dickenrichtung (Y) orientierten Oberfläche (10u) des Basiskörpers (10a), oder
(ii) auf einem sich in Tiefenrichtung (Z) an einen jeweiligen Aktuatorkörper (11a, 12a, 13a) der Aktuatoren (11, 12, 13) anschließenden Aktuator-Stufenabschnitt (11n, 12n, 13n) der Aktuatoren (11, 12, 13),
wobei zwischen Aktuator-Anschlussschichten (31d, 32d, 33d) von jeweils zwei benachbarten Aktuatoren (11, 12, 13) jeweils ein Anschlussbereich-Teilabschnitt (SOb, S1b, S2b, S3b) einer jeweiligen Ausnehmung (S0, S1, S2, S3) gelegen ist,
- eine Leiterplatte (100), die sich in der Längsrichtung (X) der Aktuatorvorrichtung (AV) über zumindest Abschnitte der Aktuator-Anschlussschichten (31d, 32d, 33d) erstreckt und deren Leiterbahnen mit den Aktuator-Anschlussschichten (31d, 32d, 33d) in elektrischem Kontakt stehen,
wobei in dem Anschlussbereich-Teilabschnitt (SOb, S1b, S2b, S3b) der jeweiligen Ausnehmung (S0, S1, S2, S3) zumindest abschnittsweise eine Verbindungsschicht (V) aus einem Harz-Verstärkungsmaterial angeordnet ist, dass die Verbindungsschicht (V) zumindest abschnittsweise einen jeweiligen Anschlussbereich-Teilabschnitt (S0b, S1b, S2b, S3b) begrenzende und einander gegenüberliegende Seitenflächen (AS1, AS2), den in die Dickenrichtung (Y) weisenden Oberflächenabschnitt (10u) des Basiskörpers (10a) und den dem Oberflächenabschnitt (10u) des Basiskörpers (10a) zugewandten Bereich der Leiterplatte (100) berührt, um die Leiterplatte (100) im Bereich des jeweiligen Anschlussbereich-Teilabschnitts (SOb, S1b, S2b, S3b) einer jeweiligen Ausnehmung (S0, S1, S2, S3) abzustützen und an den Aktuator-Anschlussschichten (31d, 32d, 33d) zu fixieren,
wobei das Harz-Verstärkungsmaterial Bismaleimid mit einem Anteil zwischen 5 Gew.-% und 90 Gew.-% des Verstärkungsmaterials enthält.

2. Aktuatorvorrichtung (AV) nach dem Anspruch 1, wobei das Harz-Verstärkungsmaterial Bismaleimid mit einem Mindestanteil von 20 Gew.-% des Verstärkungsmaterials enthält.

3. Aktuatorvorrichtung (AV) nacheinem der Ansprüche 1 bis 2, wobei das Bismaleimid aus 1,1'-(Methylendi-p-phenyllen)bismaleimid besteht oder gebildet ist.

4. Aktuatorvorrichtung (AV) nach einem der vorhergehenden Ansprüche, wobei das Harz-Verstärkungsmaterial ein Acrylat mit einem Anteil zwischen 0,1 Gew.-% und 30 Gew.-% des Verstärkungsmaterials enthält.

5. Aktuatorvorrichtung (AV) nach einem der vorhergehenden Ansprüche, wobei das Harz-Verstärkungsmaterial Acrylat mit einem Anteil zwischen 0,1 Gew.-% und 20 Gew.-% und Bismaleimid mit einem Anteil zwischen 1 Gew.-% und 80 Gew.-% enthält.

6. Aktuatorvorrichtung (AV) nach dem Anspruch 5, wobei das Acrylat aus Triethylen-glycol-dimethacrylat besteht oder gebildet ist.

7. Aktuatorvorrichtung (AV) nach einem der voranstehenden Ansprüche, wobei das Harz-Verstärkungsmaterial ein Phenolharz mit einem Anteil zwischen 0,1 Gew.-% bis 40 Gew.-% enthält.

8. Aktuatorvorrichtung (AV) nach einem der Ansprüche 1 bis 6, wobei das Harz-Verstärkungsmaterial ein Phenolharz mit einem Anteil von zumindest 0,1 Gew.-% bis 40 Gew.-%, ein Acrylat zwischen 0,1 Gew.-% und 30 Gew.-% und Bismaleimid mit einem Anteil zwischen 0,1 Gew.-% und 30 Gew.-% enthält.

9. Aktuatorvorrichtung (AV) nach einem der Ansprüche 7 bis 8, wobei das Phenolharz aus 4,4'-(Methylethyliden)bis(2-(2-propenyl)phenol) besteht oder gebildet ist.

10. Aktuatorvorrichtung (AV) nach einem der Ansprüche 1 bis 9, wobei das Harz-Verstärkungsmaterial mit Bismaleimid durch Beimischen von pulverförmigem Bismaleimid in Epoxid-Harz hergestellt ist.

11. Verfahren zur Herstellung einer Aktuatorvorrichtung nach einem der voranstehenden Ansprüche, wobei das Verfahren die folgenden Schritte aufweist:
- Anordnung des Harz-Verstärkungsmaterials in noch nicht aktiviertem Zustand in dem zumindest einen Anschlussbereich-Teilabschnitt (SOb, S1b, S2b, S3b),
- Auflegen der Leiterplatte (100) auf die Aktuator-Anschlussschichten (31d, 32d, 33d), wobei eine Menge an Harz-Verstärkungsmaterial in dem jeweiligen Anschlussbereich-Teilabschnitt (SOb, S1b, S2b, S3b) derart angeordnet ist, dass das Harz-Verstärkungsmaterial die den jeweiligen Anschlussbereich-Teilabschnitt (SOb, S1b, S2b, S3b) begrenzenden Oberflächen berührt, wobei das Harz-Verstärkungsmaterial Bismaleimid mit einem Anteil zwischen 5 Gew.-% und 90 Gew.-% des Verstärkungsmaterials enthält,
- Aktivieren des Harz-Verstärkungsmaterials durch Erwärmen desselben zum Vernetzen des Harz-Verstärkungsmaterials.

## Claims

1. Actuator device (AV), comprising:
- a main body (10) with a base body (10a) and buildup body (10b) which extends from the base body (10a) in a thickness direction (Y),
- a plurality of actuators (11, 12, 13) forming the buildup body (10b), wherein each of the actuators (11, 12, 13) extends in a depth direction (Z) and is formed of an actuator body (11a, 12a, 13a) which is made of a piezoelectric or electrostrictive material and comprises actuation electrodes which are disposed at or in the actuator and which are distanced from each other, wherein the actuators (11, 12, 13) are arranged behind each other in the longitudinal direction (X) of the actuator device (AV), wherein a actuation area segment (S0a, S1a, S2a, S3a) of a recess (S0, S1, S2, S3) is formed between each of two neighboring actuators (11, 12, 13),
wherein the actuators (11, 12, 13) comprise electroconductive actuator connection coatings (31d, 32d, 33d) which are electrically connected to the actuation electrodes of the actuators (11, 12, 13), wherein the actuator connection coatings (31d, 32d, 33d) at least in sections are disposed:
(i) either on a surface (10u) of the base body (10a) which is oriented in the thickness direction (Y),
(ii) or on an actuator step section (11n, 12n, 13n) of the actuators (11, 12, 13), wherein the actuator step section joins in depth direction (Z) a respective actuator body (11a, 12a, 13a) of the actuators (11, 12, 13),
wherein between actuator connection coatings (31d, 32d, 33d) of respective two neighboring actuators (11, 12, 13) a respective connection area segment (SOb, S1b, S2b, S3b) of a respective recess (S0, S1, S2, S3) is disposed,
- a printed circuit board (100) which extends in the longitudinal direction (X) of the actuator device (AV) over at least sections of the actuator connection coatings (31d, 32d, 33d), wherein the conductive paths of the printed circuit board are in electrical contact with the actuator connection coatings (31d, 32d, 33d),
wherein in the connection area segment (SOb, S1b, S2b, S3b) of the respective recess (S0, S1, S2, S3) at least in sections a connection layer (V) is disposed which is made of a resin reinforcement material, wherein the connection layer (V) at least in sections contacts side surfaces (AS1, AS2) which delimit a respective connection area segment (SOb, S1b, S2b, S3b) and which are opposed to each other, the surface section (10u) of the base body (10a) which is oriented in the thickness direction (Y), the area of the printed circuit board (100) which faces the surface section (10u) of the base body (10a), in order to support the printed circuit board (100) in the area of the respective connection area segments (S0b, S1b, S2b, S3b) of a respective recess (S0, S1, S2, S3) and to fix the printed circuit board to the actuator connection coatings (31d, 32d, 33d),
wherein the resin reinforcement material contains bismaleimide with a portion between 5 percent by weight and 90 percent by weight of the reinforcement material.

2. Actuator device (AV) according to claim 1, wherein the resin reinforcement material contains bismaleimide with a minimum portion of 20 percent by weight of the reinforcement material.

3. Actuator device (AV) according to one of claims 1 to 2, wherein the bismaleimide consists of or is formed of 1,1'-(Methylenedi-p-phenylene)bismaleimide.

4. Actuator device (AV) according to one of the preceding claims, wherein the resin reinforcement material contains an acrylate with a portion between 0,1 percent by weight and 30 percent by weight of the reinforcement material.

5. Actuator device (AV) according to one of the preceding claims, wherein the resin reinforcement material contains acrylate with a portion between 0,1 percent by weight and 20 percent by weight and bismaleimide with a portion between 1 percent by weight and 80 percent by weight.

6. Actuator device (AV) according to claim 5, wherein the acrylate consists of or is formed of triethylene-glycol-dimethacrylate.

7. Actuator device (AV) according to one of the preceding claims, wherein the resin reinforcement material contains a phenolic resin with a portion between 0,1 percent by weight and 40 percent by weight.

8. Actuator device (AV) according to one of claims 1 to 6, wherein the resin reinforcement material contains a phenolic resin with a portion of at least 0,1 percent by weight to 40 percent by weight, an acrylate between 0,1 percent by weight and 30 percent by weight and bismaleimide with a portion between 0,1 percent by weight and 30 percent by weight.

9. Actuator device (AV) according to one of claims 7 to 8, wherein the phenolic resin consists of or is formed of 4,4'-(methylethylidene)bis(2-(2-propenyl)phenol).

10. Actuator device (AV) according to one of claims 1 to 9, wherein the resin reinforcement material with bismaleimide is produced by adding powdery bismaleimide to epoxy resin.

11. Method for manufacturing an actuator device according to one of the preceding claims, wherein the method comprises the following steps:
- disposing resin reinforcement material in the at least one connection area segment (S0b, S1b, S2b, S3b), wherein the resin reinforcement material is in a not yet activated state,
- applying of the printed circuit board (100) onto the actuator connection coatings (31d, 32d, 33d), wherein an amount of an resin reinforcement material is disposed in the respective connection area segment (SOb, S1b, S2b, S3b) such that the resin reinforcement material contacts the surfaces which limit the respective connection area segment (SOb, S1b, S2b, S3b), wherein the resin reinforcement material contains bismaleimide with a portion between 5 percent by weight and 90 percent by weight of the reinforcement material,
- activating the resin reinforcement material by heating the same to crosslink the resin reinforcement material.

## Revendications

1. Dispositif actionneur (AV), comportant :
- un corps principal (10), pourvu d'un corps de base (10a) et d'une superstructure (10b) s'étendant dans une direction d'épaisseur (Y) à partir du corps de base (10a)
- une multiplicité d' actionneurs (11, 12, 13) formant la superstructure (10b) et s'étendant respectivement dans une direction de profondeur (Z) et formés d'un corps d'actionneur (11a, 12a, 13a) en une matière piézoélectrique ou électrorestrictive et d'électrodes d'actionnement écartées les unes des autres, placées sur ou dans ce dernier, les actionneurs (11, 12, 13) étant placés les uns derrière les autres dans la direction longitudinale (X) du dispositif actionneur (AV), entre chaque fois deux actionneurs voisins étant conçu un segment partiel de zone d'actionnement (S0a, S1a, S2a, S3a) d'un évidement (S0, S1, S2, S3),
les actionneurs (11, 12, 13) comportant des couches de connexion d'actionneurs (31d, 32d, 33d) conductrices d'électricité, qui sont en liaison électrique avec les électrodes d'actionnement des actionneurs (11, 12, 13), les couches de connexion d'actionneurs (31d, 32d, 33d) se situant au moins par endroits
(i) soit sur une surface (10u) du corps de base (10a) orientée dans la direction d'épaisseur (Y), ou
(ii) sur un segment à gradins d'actionneur (11 n, 12n, 13n) des actionneurs (11, 12, 13) se raccordant dans la direction de profondeur (Z) sur un corps d'actionneur (11a, 12a, 13a) respectif des actionneurs (11, 12, 13),
entre des couches de connexion d'actionneurs (31d, 32d, 33d) de respectivement deux actionneurs (11, 12, 13) voisins se situant respectivement un segment partiel de zone de connexion (S0b, S1b, S2b, S3b) d'un évidement (S0, S1, S2, S3) respectif,
- une carte de circuits imprimés (100), qui dans la direction longitudinale (X) du dispositif actionneur (AV) s'étend sur au moins des segments des couches de connexion d'actionneurs (31d, 32d, 33d) et dont les pistes conductives sont en contact électrique avec les couches de connexion d'actionneurs (31d, 32d, 33d),
dans le segment partiel de zone de connexion (S0b, S1b, S2b, S3b) de l'évidement (S0, S1, S2, S3) respectif étant placée au moins par endroits une couche de liaison (V) en une matière de renfort résineuse, de sorte que la couche de liaison (V) touche au moins par endroits des surfaces latérales (AS1, AS2) délimitant un segment partiel de zone de connexion (SOb, S1b, S2b, S3b) et mutuellement opposées du segment superficiel (10u) du corps de base (10a) dirigé dans la direction d'épaisseur (Y) et la zone carte de circuits imprimés (100) dirigée vers le segment superficiel (10u) du corps de base (10a), pour soutenir la carte de circuits imprimés (100) dans la zone du segment partiel de zone de connexion (SOb, S1b, S2b, S3b) d'un évidement (S0, S1, S2, S3) respectif et la fixer sur les couches de connexion d'actionneurs (31d, 32d, 33d),
la matière de renfort résineuse contenant du bis-maléimide, dans une part comprise entre 5 % en poids et 90 % en poids de la matière de renfort.

2. Dispositif actionneur (AV) selon la revendication 1, la matière de renfort résineuse contenant du bis-maléimide dans une part minimale de 20 % en poids de la matière de renfort.

3. Dispositif actionneur (AV) selon l'une quelconque des revendications 1 à 2, le bis-maléimide étant constitué ou formé de 1,1'- (méthylène di-p-phényllen)bis-maléimide.

4. Dispositif actionneur (AV) selon l'une quelconque des revendications précédentes, la matière de renfort résineuse contenant un acrylate dans une part comprise entre 0,1 % en poids et 30 % en poids de la matière de renfort.

5. Dispositif actionneur (AV) selon l'une quelconque des revendications précédentes, la matière de renfort résineuse contenant un acrylate dans une part comprise entre 0,1 % en poids et 20 % en poids et du bis-maléimide dans une part comprise entre 1 % en poids et 80 % en poids.

6. Dispositif actionneur (AV) selon la revendication 5, l'acrylate étant constitué ou formé d'un triéthylène-glycol-diméthacrylate.

7. Dispositif actionneur (AV) selon l'une quelconque des revendications précédentes, la matière de renfort résineuse contenant une résine phénolique dans une part comprise entre 0,1 % en poids et 40 % en poids.

8. Dispositif actionneur (AV) selon l'une quelconque des revendications 1 à 6, la matière de renfort résineuse contenant une résine phénolique dans une part comprise entre 0,1 % en poids et 40 % en poids, un acrylate dans une part comprise entre 0,1 % en poids et 30 % en poids et du bis-maléimide dans une part comprise entre 0,1 % en poids et 30 % en poids.

9. Dispositif actionneur (AV) selon l'une quelconque des revendications 7 à 8, la matière de renfort résineuse étant constituée ou formée de 4,4'-(méthyléthylidène)bis(2-(2-propényl)phénol).

10. Dispositif actionneur (AV) selon l'une quelconque des revendications 1 à 9, la matière de renfort résineuse pourvue de bis-maléimide étant fabriquée par ajout de bis-maléimide dans une résine époxy.

11. Procédé, destiné à fabriquer un dispositif actionneur selon l'une quelconque des revendications précédentes, le procédé comportant les étapes suivantes consistant à :
- placer la matière de renfort résineuse dans l'état encore activé dans l'au moins un segment partiel de zone de connexion (S0b, S1b, S2b, S3b),
- poser la carte de circuits imprimés (100) sur les couches de connexion d'actionneurs (31d, 32d, 33d), une quantité de matière de renfort résineuse étant placée dans segment partiel de zone de connexion (SOb, S1b, S2b, S3b) respectif, de telle sorte que la matière de renfort résineuse soit en contact avec la surface délimitant le segment partiel de zone de connexion (SOb, S1b, S2b, S3b) respectif, la matière de renfort résineuse contenant du bis-maléimide, dans une part comprise entre 5 % en poids et 90 % en poids de la matière de renfort,
- activer la matière de renfort résineuse en la faisant chauffer, pour réticuler la matière de renfort résineuse.
